(19)

**Europäisches Patentamt**
**European Patent Office**
**Office européen des brevets**

(11)　**EP 1 697 928 B1**

(12)　# EUROPÄISCHE PATENTSCHRIFT

(45) Veröffentlichungstag und Bekanntmachung des Hinweises auf die Patenterteilung:
**02.09.2009　Patentblatt 2009/36**

(51) Int Cl.:
*G10L 19/00* (2006.01)　　*G10L 19/14* (2006.01)
*G10L 19/02* (2006.01)

(21) Anmeldenummer: **05707322.3**

(86) Internationale Anmeldenummer:
**PCT/EP2005/001363**

(22) Anmeldetag: **10.02.2005**

(87) Internationale Veröffentlichungsnummer:
**WO 2005/078705 (25.08.2005 Gazette 2005/34)**

(54) **Audiokodierung**

AUDIO ENCODING

CODAGE AUDIO

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **13.02.2004　DE 102004007191**

(43) Veröffentlichungstag der Anmeldung:
**06.09.2006　Patentblatt 2006/36**

(73) Patentinhaber: **Fraunhofer-Gesellschaft zur Förderung der angewandten Forschung e.V. 80686 München (DE)**

(72) Erfinder:
- **SCHULLER, Gerald 99089 Erfurt (DE)**
- **WABNIK, Stefan 98693 Ilmenau (DE)**
- **HIRSCHFELD, Jens 36266 Heringen (DE)**
- **LUTZKY, Manfred 90427 Nürnberg (DE)**

(74) Vertreter: **Schoppe, Fritz et al Schoppe, Zimmermann, Stöckeler & Zinkler Patentanwälte Postfach 246 82043 Pullach bei München (DE)**

(56) Entgegenhaltungen:
**WO-A-01/33718**

- **SCHULLER G D T ET AL: "PERCEPTUAL AUDIO CODING USING ADAPTIVE PRE- AND POST-FILTERS AND LOSSLESS COMPRESSION" IEEE TRANSACTIONS ON SPEECH AND AUDIO PROCESSING, IEEE INC. NEW YORK, US, Bd. 10, Nr. 6, September 2002 (2002-09), Seiten 379-390, XP001219570 ISSN: 1063-6676**
- **JUIN-HWEY CHEN: "A high-fidelity speech and audio codec with low delay and low complexity" ACOUSTICS, SPEECH, AND SIGNAL PROCESSING, 2000. ICASSP '00. PROCEEDINGS. 2000 IEEE INTERNATIONAL CONFERENCE ON 5-9 JUNE 2000, PISCATAWAY, NJ, USA,IEEE, Bd. 2, 5. Juni 2000 (2000-06-05), Seiten 1161-1164, XP010504934 ISBN: 0-7803-6293-4**

EP 1 697 928 B1

**Beschreibung**

Die vorliegende Erfindung bezieht sich auf Audiocodierer bzw. -decodierer bzw. die Audiocodierung im allgemeinen und insbesondere auf Audiocodierungen, die eine Codierung von Audiosignalen mit einer kurzen Verzögerungszeit ermöglichen.

Das derzeit bekannteste Audiokompressionsverfahren ist das MPEG-1 Layer III. Bei diesem Kompressionsverfahren werden die Abtast- bzw. Audiowerte eines Audiosignals verlustbehaftet in ein codiertes Signal codiert. Anders ausgedrückt werden bei der Kompression Irrelevanz und Redundanz des ursprünglichen Audiosignals reduziert bzw. idealer Weise entfernt. Um dies zu erzielen, werden durch ein psychoakustisches Modell simultane und zeitliche Maskierungen erkannt, d.h. es wird eine sich zeitlich ändernde, vom Audiosignal abhängige Maskierungsschwelle berechnet bzw. bestimmt, die angibt, ab welcher Lautstärke Töne einer bestimmten Frequenz für das menschliche Gehör erst wahrnehmbar sind. Diese Information wird wiederum zur Codierung des Signals verwendet, indem die Spektralwerte des Audiosignals abhängig von der Maskierungsschwelle genauer, weniger genau oder gar nicht quantisiert und in das codierte Signal eingebunden werden.

Audiokompressionsverfahren, wie das MP3-Format, erfahren dann eine Grenze in ihrer Anwendbarkeit, wenn es darum geht, Audiodaten über einen bitratenbegrenzten Übertragungskanal einerseits komprimiert, andererseits aber mit möglichst geringer Verzögerungszeit zu übertragen. Bei einigen Anwendungen spielt die Verzögerungszeit keine Rolle, wie z.B. bei der Archivierung von Audioinformationen. Audiocoder mit niedriger Verzögerung, manchmal auch "Ultra Low Delay Coder" genannt, sind jedoch dort notwendig, wo es um zeitkritische Übertragungen von Audiosignalen geht, wie z.B. beim Tele-Conferencing, bei drahtlosen Lautsprechern oder Mikrophonen. Für diese Anwendungsgebiete wird in dem Artikel von Schuller G. usw. "Perceptual Audio Coding using Adaptive Pre- and Post-Filters and Lossless Compression", IEEE Transactions on Speech and Audio Processing, Bd. 10, Nr. 6, September 2002, S. 379 - 390, eine Audiocodierung vorgeschlagen, bei der die Irrelevanzreduktion und die Redundanzreduktion nicht basierend auf einer einzigen Transformation, sondern auf zwei getrennten Transformationen durchgeführt werden.

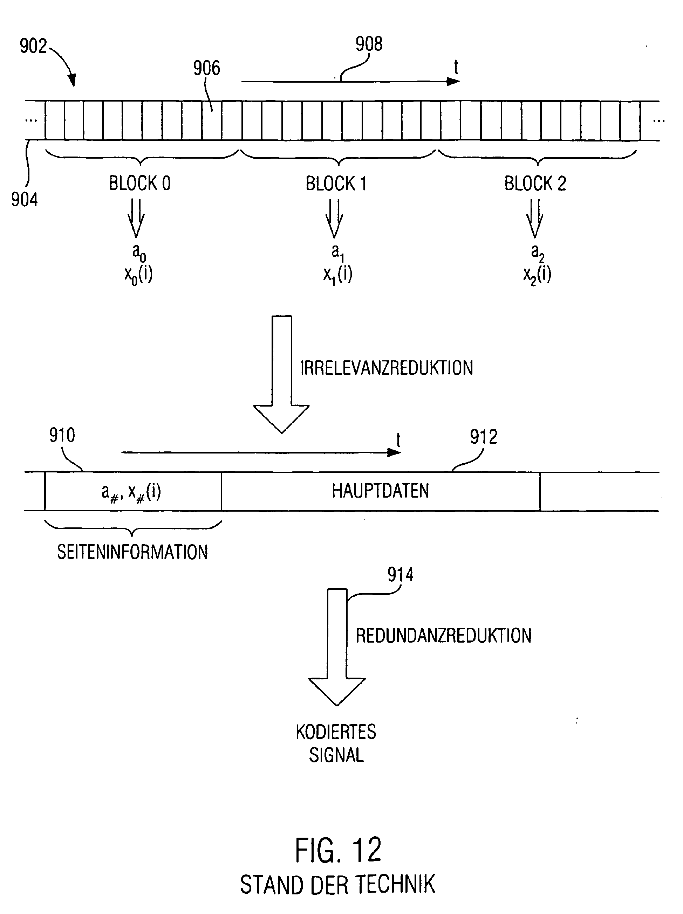

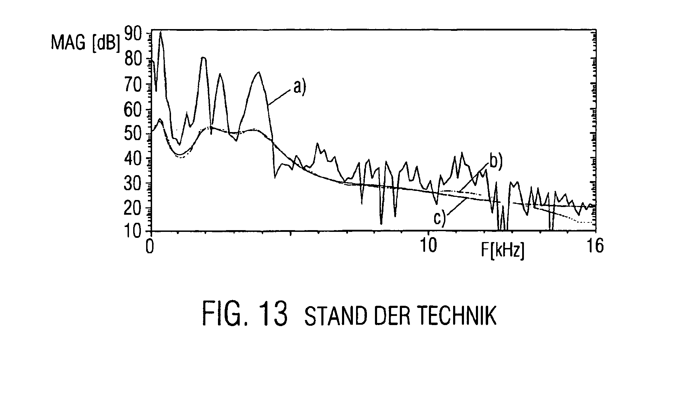

Das Prinzip wird im folgenden Bezug nehmend auf die Fig. 12 und 13 erläutert. Die Codierung geht von einem Audiosignal 902 aus, das bereits abgetastet worden ist und deshalb bereits als eine Folge 904 von Audio- bzw. Abtastwerten 906 vorliegt, wobei durch einen Pfeil 908 die zeitliche Reihenfolge der Audiowerte 906 angedeutet ist. Für aufeinanderfolgende Blöcke von Audiowerten 906, die mit aufsteigender Nummerierung mit "Block#" gekennzeichnet sind, wird mittels eines psychoakustischen Modells eine Mithörschwelle berechnet. Fig. 13 zeigt beispielsweise ein Diagramm, bei dem über die Frequenz f mit der Kurve a das Spektrum eines Signalblocks aus 128 Audiowerten 906 und bei b die Maskierungsschwelle, wie sie durch ein psychoakustisches Modell berechnet worden ist, in logarithmischen Einheiten aufgetragen ist. Die Maskierungsschwelle zeigt, wie bereits erwähnt, an, bis zu welcher Intensität Frequenzen für das menschliche Ohr unhörbar sind, nämlich alle Töne unterhalb der Maskierungsschwelle b. Basierend auf den für jeden Block berechneten Mithörschwellen wird nun eine Irrelevanzreduktion durch Steuerung eines parametrisierbaren Filters gefolgt von einem Quantisierer erzielt. Für ein parametrisierbares Filter wird eine Parametrisierung derart berechnet, daß die Frequenzantwort desselben dem Inversen des Betrags der Maskierungsschwelle entspricht. Diese Parametrisierung ist in Fig. 12 durch $x_\#(i)$ angedeutet.

Nach der Filterung der Audiowerte 906 erfolgt eine Quantisierung mit konstanter Schrittweite, beispielsweise eine Rundungsoperation auf die nächste Ganzzahl. Das hierdurch hervorgerufene Quantisierungsrauschen ist weißes Rauschen. Decoderseitig wird das gefilterte Signal wieder mit einem parametrisierbaren Filter "rücktransformiert", dessen Übertragungsfunktion auf den Betrag der Maskierungsschwelle selbst eingestellt wird. Hierdurch wird nicht nur das gefilterte Signal wieder dekodiert sondern auch das Quantisierungsrauschen decoderseitig an die Form der Maskierungsschwelle angepaßt. Damit das Quantisierungsrauschen möglichst genau der Maskierungsschwelle entspricht, wird codiererseitig zu jedem Parametersatz bzw. zu jeder Parametrisierung ferner ein Verstärkungswert $a_\#$ berechnet, der vor der Quantisierung auf das gefilterte Signal angewendet wird. Damit decodiererseitig die Rücktransformation durchgeführt werden kann, werden der Verstärkungswert a und die Parametrisierung x als Seiteninformationen 910 neben den eigentlichen Hauptdaten, nämlich den quantisierten, gefilterten Audiowerten 912, zum Codierer übertragen. Zur Redundanzreduktion 914 werden diese Daten, d.h. Seiteninformationen 910 und Hauptdaten 912, noch einer verlustlosen Kompression, nämlich einer Entropiecodierung, unterzogen, wodurch das codierte Signal erhalten wird.

Obiger Artikel schlägt als Blockgröße eine Größe von 128 Abtastwerten 906 vor. Hierdurch wird eine relativ kurze Verzögerung von 8 ms bei 32 kHz Abtastrate ermöglicht. Bezüglich der detaillierten Implementierung wird in dem Artikel noch beschrieben, daß zur Effizienzsteigerung der Seiteninformationscodierung die Seiteninformationen, nämlich die Koeffizienten $x_\#$ und $a_\#$ nur dann übertragen werden, wenn genügend Änderung im Vergleich zu einem vorher übertragenen Parametersatz vorhanden ist, d.h. wenn die Änderung einen bestimmten Schwellwert überschreitet. Zudem wird beschrieben, daß die Implementierung vorzugsweise so vorgenommen wird, daß ein aktueller Parametersatz nicht unmittelbar auf alle zu dem jeweiligen Block gehörenden Abtastwerte angewendet wird, sondern daß eine lineare Interpolation der Filterkoeffizienten $x_\#$ verwendet wird, um hörbare Artefakte zu vermeiden. Um die lineare Interpolation der Filterkoeffizienten durchzuführen, wird eine Lattice-Struktur für das Filter vorgeschlagen, um das Auftreten von Instabilitäten zu verhindern. Für den Fall, daß ein codiertes Signal mit einer gesteuerten Bitrate erwünscht ist, schlägt der Artikel noch vor, das gefilterte und mit dem zeitabhängigen Verstärkungsfaktor a skalierte Signal selektiv noch mit einem Faktor ungleich 1 zu multiplizieren bzw. zu schwächen, so daß zwar hörbare Störungen entstehen, aber die Bitrate an aufwendig zu codierenden Stellen des Audiosignals reduziert werden kann.

Obwohl das in dem oben zitierten Artikel beschriebene Audiocodierungsschema die Verzögerungszeit für viele Anwendungen bereits ausreichend reduziert, besteht ein Problem bei obigem Schema darin, daß aufgrund der Notwendigkeit, die Maskierungsschwelle bzw. die Übertragungsfunktion des codiererseitigen Filters, im folgenden als Prefilter bezeichnet, übertragen zu müssen, der Übertragungskanal relativ hoch belastet wird, obgleich ja die Filterkoeffizienten nur bei Überschreiten einer vorbestimmten Schwelle übertragen werden.

Ein weiterer Nachteil obigen Codierschemas besteht darin, daß aufgrund der Tatsache, daß die Maskierungsschwelle bzw. das Inverse hiervon durch den zu übertragenden Parametersatz $x_{\#}$ decodierseitig zur Verfügung gestellt werden muß, ein Kompromiß zwischen einerseits einer möglichst niedrigen Bitrate bzw. einem hohen Kompressionsverhältnis und andererseits einer möglichst genauen Approximation bzw. Parametrisierung der Maskierungsschwelle bzw. dem Inversen hiervon zu treffen ist. Unvermeidlich ist es deshalb, daß das durch obiges Audiocodierschema an die Maskierungsschwelle angepaßte Quantisierungsrauschen an einigen Frequenzbereichen die Maskierungsschwelle überschreitet und deshalb für den Hörer zu hörbaren Audiostörungen führt.

Fig. 13 zeigt beispielsweise mit der Kurve c die parametrisierte Frequenzantwort des decoderseitigen parametrisierbaren Filters. Wie es zu sehen ist, gibt es Bereiche, an denen die Übertragungsfunktion des decoderseitigen Filters, im folgenden auch als Postfilter bezeichnet, die Maskierungsschwelle b überschreitet. Das Problem vergrößert sich nun dadurch, daß die Parametrisierung nur intermittierend bei genügend Änderung zwischen den Parametrisierungen übertragen und dazwischen interpoliert wird. Eine Interpolation der Filterkoeffizienten $x_{\#}$, wie in dem Artikel vorgeschlagen, allein führt bei Konstanthalten des Verstärkungswertes $a_{\#}$ von Stützstelle zu Stützstelle bzw. von neuer Parametrisierung zu neuer Parametrisierung zu hörbaren Störungen. Auch wenn die in dem Artikel vorgeschlagene Interpolation auch auf den Seiteninformationswert $a_{\#}$, d.h. die übertragenen Verstärkungswerte, angewendet wird, können in dem decodiererseitig ankommenden Audiosignal hörbare Audioartefakte verbleiben.

Ein weiteres Problem bei dem Audiocodierschema nach Fig. 12 bzw. 13 besteht darin, daß das gefilterte Signal aufgrund der frequenzselektiven Filterung eine nicht vorhersehbare Form annehmen kann, bei der sich insbesondere aufgrund einer zufälligen Überlagerung vieler einzelner Oberwellen ein einzelner oder einzelne Audiowerte des codierten Signals zu sehr hohen Werten aufsummieren, die aufgrund ihres seltenen Auftretens wiederum bei der anschließenden Redundanzreduktion zu einem schlechteren Kompressionsverhältnis führen.

Die Aufgabe der vorliegenden Erfindung besteht darin, ein effektiveres Audiocodierschema zu schaffen.

Diese Aufgabe wird durch ein Verfahren gemäß Anspruch 8 oder 10 und eine Vorrichtung gemäß Anspruch 1 oder 9 gelöst.

Eine erfindungsgemäße Codierung eines Audiosignals einer Folge von Audiowerten in ein codiertes Signal umfaßt das Ermitteln einer ersten Mithörschwelle für einen ersten Block von Audiowerten der Folge von Audiowerten und einer zweiten Mithörschwelle für einen zweiten Block von Audiowerten der Folge von Audiowerten; das Berechnen einer Version einer ersten Parametrisierung eines parametrisierbaren Filters, so daß dessen Übertragungsfunktion in etwa dem Inversen des Betrags der ersten Mithörschwelle entspricht, und einer Version einer zweiten Parametrisierung des parametrisierbaren Filters, so daß dessen Übertragungsfunktion in etwa dem Inversen des Betrags der zweiten Mithörschwelle entspricht; das Filtern eines vorbestimmten Blocks von Audiowerten der Folge von Audiowerten mit dem parametrisierbaren Filter unter Verwendung einer vorbestimmten Parametrisierung, die in vorbestimmter Weise von der Version der zweiten Parametrisierung abhängt, um einen zu dem vorbestimmten Block korrespondierenden Block von gefilterten Audiowerten zu erhalten; das Quantisieren der gefilterten Audiowerte, um einen Block von quantisierten, gefilterten Audiowerten zu erhalten; die Bildung einer Kombination der Version der ersten Parametrisierung und der Version der zweiten Parametrisierung, die zumindest eine Differenz zwischen der Version der ersten Parametrisierung und der Version der zweiten Parametrisierung umfaßt; und das Einbinden von Informationen, aus denen die quantifizierten, gefilterten Audiowerte und eine Version der ersten Parametrisierung herleitbar sind, und die die Kombination umfassen, in das codierte Signal.

Der Kerngedanke der vorliegenden Erfindung besteht darin, daß durch die Übertragung von Differenzen von aufeinanderfolgenden Parametrisierungen ein höheres Kompressionsverhältnis erzielt werden kann.

Findet die Übertragung der Parametrisierungen zudem nur dann statt, wenn zwischen denselben ein ausreichender Unterschied besteht, besteht die Erkenntnis der vorliegenden Erfindung insbesondere ebenfalls darin, daß auch in diesem Fall, obwohl die Parametrisierungsdifferenzen das Mindestunterscheidungsmaß nicht unterschreiten, dennoch die Übertragung von Differenzen zwischen zwei Parametrisierungen anstelle der einer Parametrisierung eine Kompressionserhöhung liefert, die den zusätzlichen Aufwand der Differenzbildung codiererseitig und Summenbildung decoderseitig mehr als aufwiegt.

Gemäß einem Ausführungsbeispiel der vorliegenden Erfindung werden die reinen Differenzen zwischen aufeinanderfolgenden Parametrisierungen übertragen, während gemäß einem weiteren Ausführungsbeispiel von diesen Differenzen auch noch die Mindestschwelle abgezogen wird, ab der Parametrisierungen neuer Stützstellen erst übertragen werden.

Bevorzugte Ausführungsbeispiele der vorliegenden Erfindung werden nachfolgend Bezug nehmend auf die beiliegenden Zeichnungen näher erläutert. Es zeigen:

Fig. 1      ein Blockschaltbild eines Audiocodierers gemäß einem Ausführungsbeispiel der vorliegenden Erfindung;

Fig. 2      ein Flußdiagramm zur Veranschaulichung der Arbeitsweise des Audiocodierers von Fig. 1 am Dateneingang;

Fig. 3      ein Flußdiagramm zur Veranschaulichung der Arbeitsweise des Audiocodierers von Fig. 1 im Hinblick auf die Auswertung des eingehenden Audiosignals durch ein psychoakustisches Modell;

Fig. 4      ein Flußdiagramm zur Veranschaulichung der Arbeitsweise des Audiocodierers von Fig. 1 im Hinblick auf die Anwendung der durch das psychoakustische Modell erhaltenen Parameter auf das eingehende Audiosignal;

Fig. 5a      ein schematisches Diagramm zur Veranschaulichung des eingehenden Audiosignals, der Folge von Audiowerten, aus der dasselbe besteht, und der Arbeitsschritte von Fig. 4 in Relation zu den Audiowerten;

Fig. 5b      ein schematisches Diagramm zur Veranschaulichung des Aufbaus des codierten Signals;

Fig. 6      ein Flußdiagramm zur Veranschaulichung der Arbeitsweise des Audiocodierers von Fig. 1 im Hinblick auf die Endverarbeitung bis zum codierten Signal;

Fig. 7a      ein Diagramm in dem ein Ausführungsbeispiel für eine Quantisierungsstufenfunktion gezeigt ist;

Fig. 7b      ein Diagramm in dem ein weiteres Ausführungsbeispiel für eine Quantisierungsstufenfunktion gezeigt ist;

Fig. 8      ein Blockschaltbild eines Audiodecodierers, der zur Decodierung eines durch den Audiocodierer von Fig. 1 codierten Audiosignals in der Lage ist, gemäß einem Ausführungsbeispiel der vorliegenden Erfindung;

Fig. 9      ein Flußdiagramm zur Veranschaulichung der Arbeitsweise des Decodierers von Fig. 8 am Dateneingang;

Fig. 10      ein Flußdiagramm zur Veranschaulichung der Arbeitsweise des Decodierers von Fig. 8 im Hinblick auf die Zwischenspeicherung der vordecodierten, quantisierten, gefilterten Audiodaten und der Verarbeitung der Audioblöcke ohne zugehörige Seiteninformationen;

Fig. 11      ein Flußdiagramm zur Veranschaulichung der Arbeitsweise des Decodierers von Fig. 8 im Hinblick auf die eigentliche Rückfilterung;

Fig. 12      ein schematisches Diagramm zur Veranschaulichung eines herkömmlichen Audiocodierschemas mit kurzer Verzögerungszeit; und

Fig. 13      ein Diagramm, in dem exemplarisch ein Spektrum eines Audiosignals, eine Mithörschwelle desselben und die Übertragungsfunktion des Postfilters im Decodierer gezeigt sind.

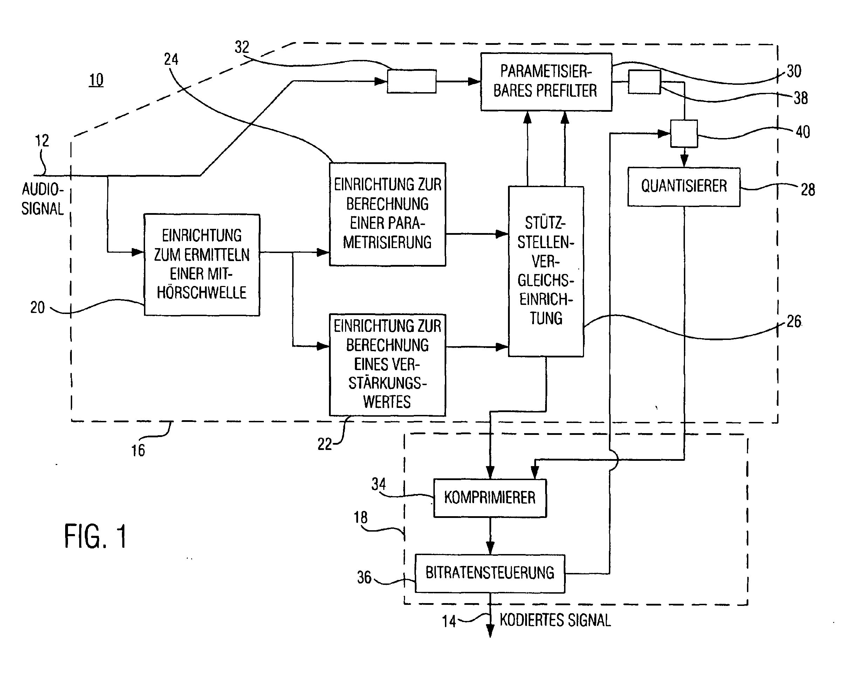

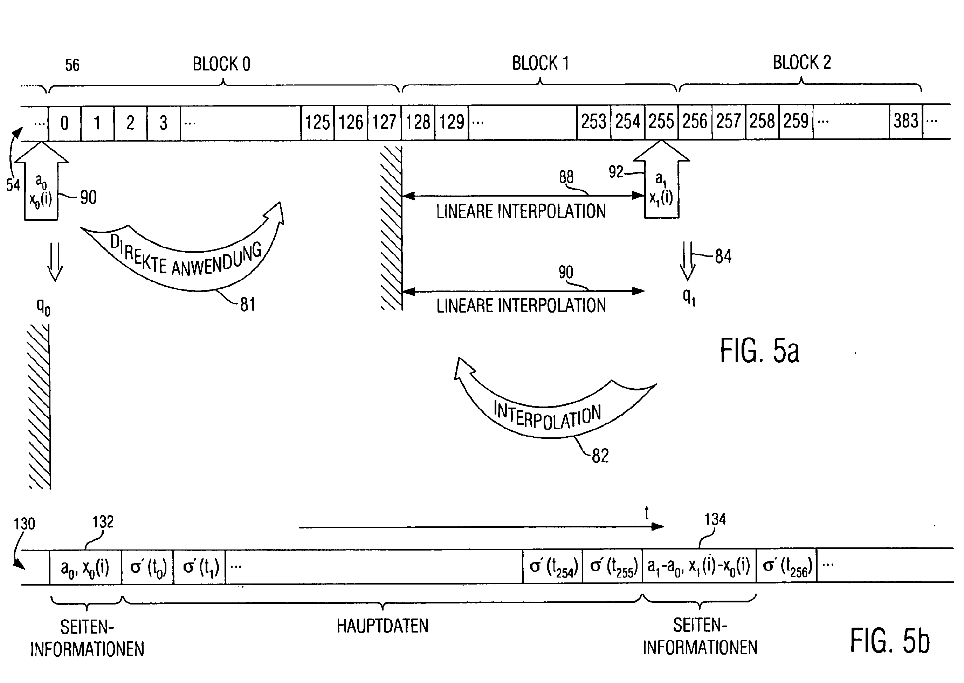

Fig. 1 zeigt einen Audiocodierer gemäß einem Ausführungsbeispiel der vorliegenden Erfindung. Der Audiocodierer, der allgemein mit 10 angezeigt ist, umfaßt zunächst einen Dateneingang 12, an dem derselbe das zu codierende Audiosignal empfängt, das, wie es später Bezug nehmend auf Fig. 5a noch näher erläutert werden wird, aus einer Folge von Audiowerten bzw. Abtastwerten besteht, sowie einen Datenausgang, an dem das codierte Signal ausgegeben wird, dessen Informationsinhalt Bezug nehmend auf Fig. 5b näher erörtert wird.

Der Audiocodierer 10 von Fig. 1 gliedert sich in einen Irrelevanzreduktionsteil 16 und einen Redundanzreduktionsteil 18. Der Irrelevanzreduktionsteil 16 umfaßt eine Einrichtung 20 zum Ermitteln einer Mithörschwelle, eine Einrichtung 22 zur Berechnung eines Verstärkungswertes, eine Einrichtung 24 zur Berechnung einer Parametrisierung, eine Stützstellenvergleichseinrichtung 26, einen Quantisierer 28 und ein parametrisierbares Prefilter 30 sowie einen Eingangs-FIFO- (first-in-first-out) Puffer 32, einen Buffer oder Speicher 38 und einen Multiplizierer oder eine Multiplziereinrichtung 40. Der Redundanzreduktionsteil 18 umfaßt einen Komprimierer 34 und eine Bitratensteuerung 36.

Irrelevanzreduktionsteil 16 und Redundanzreduktionsteil 18 sind seriell in dieser Reihenfolge zwischen Dateneingang 12 und Datenausgang 14 geschaltet. Insbesondere ist der Dateneingang 12 mit einem Dateneingang der Einrichtung 20 zum Ermitteln einer Mithörschwelle und einem Dateneingang des Eingangspuffers 32 verbunden. Ein Datenausgang der Einrichtung 20 zum Ermitteln einer Mithörschwelle ist mit einem Eingang der Einrichtung 24 zur Berechnung einer Parametrisierung sowie mit einem Dateneingang der Einrichtung 22 zur Berechnung eines Verstärkungswertes verbunden, um an dieselben eine ermittelte Mithörschwelle weiterzuleiten. Die Einrichtungen 22 und 24 berechnen basierend auf der Mithörschwelle eine Parametrisierung bzw. einen Verstärkungswert und sind mit der Stützstellenvergleichseinrichtung 26 verbunden, um an dieselbe diese Ergebnisse weiterzuleiten. Die Stützstellenvergleichseinrichtung 26 leitet je nach einem Vergleichsergebnis, wie es im folgenden noch erörtert werden wird, die von den Einrichtungen 22 und 24 berechneten Ergebnisse als Eingangsparameter bzw. Parametrisierung an das parametrisierbare Prefilter 30 weiter. Das parametrisierbare Prefilter 30 ist zwischen einen Datenausgang des Eingangspuffers 32 und einen Dateneingang des Buffers 38 geschaltet. Zwischen einen Datenausgang des Buffers 38 und den Quantisierer 28 ist der Multiplizierer 40 geschaltet. Der Quantisierer 28 leitet an den Redundanzreduktionsteil 18 gegebenenfalls multiplizierte bzw. skalierte, auf jeden Fall aber quantisierte, gefilterte Audiowerte weiter, und zwar genau genommen an einen Dateneingang des Komprimierers 34. Die Stützstellenvergleichseinrichtung 26 leitet an den Redundanzreduktionsteil 18 Informationen weiter, aus denen die an das parametrisierbare Prefilter 30 weitergeleiteten Eingangsparameter herleitbar sind, und zwar genau genommen an einen weiteren Dateneingang des Komprimierers 34. Die Bitratensteuerung ist über eine Steuerverbindung mit einem Steuereingang des Multiplizierer 40 verbunden, um dafür zu sorgen, dass die quantisierten, gefilterten Audiowerte, wie sie von dem Prefilter 30 erhalten werden, durch den Multiplizierer 40 mit einem geeigneten Multiplikator multipliziert werden, wie es im folgenden noch detaillierter erörtert wird. Die Bitratensteuerung 36 ist zwischen einen Datenausgang des Komprimierers 34 und den Datenausgang 14 des Audiocodierers 10 geschaltet, um den Multiplikator für den Multiplizierer 40 geeignet zu bestimmen. Beim ersten Durchlauf jeden Audiowerts durch den Quantisierer 40 ist der Multiplikator zunächst auf einen geeigneten Skalierungsfaktor eingestellt, wie z.B. 1. Der Buffer 38 speichert jedoch weiterhin jeden gefilterten Audiowert, um der Bitratensteuerung 36, wie im folgenden beschrieben, Gelegenheit zu geben, den Multiplikator für einen weiteren Durchlauf eines Blocks von Audiowerten zu ändern. Wird eine solche Änderung durch die Bitratensteuerung 36 nicht angezeigt, so kann der Buffer 38 den durch diesen Block eingenommenen Speicher freigeben.

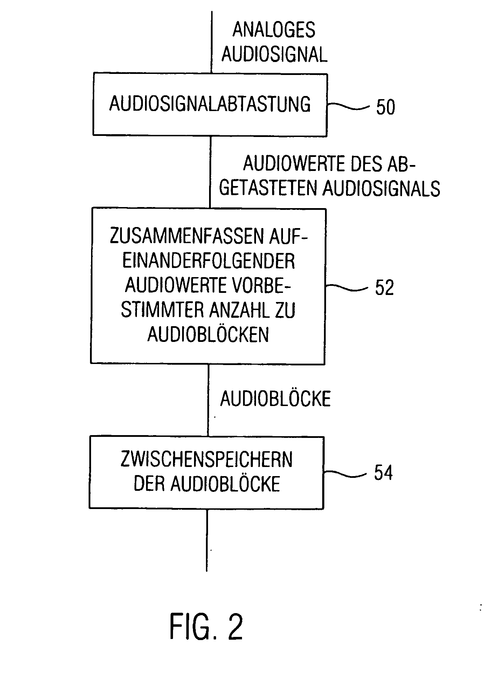

Nachdem im Vorhergehenden der Aufbau des Audiocodierers von Fig. 1 beschrieben worden ist, wird im folgenden Bezug nehmend auf die Fig. 2 - 7b dessen Funktionsweise beschrieben.

Wie es Fig. 2 zu entnehmen ist, ist das Audiosignal, wenn es den Dateneingang 12 erreicht, bereits durch Audiosignalabtastung 50 aus einem analogen Audiosignal erhalten worden. Die Audiosignalabtastung wird mit einer vorbestimmten Abtastfrequenz durchgeführt, die üblicherweise zwischen 32 - 48 kHz liegt. Am Dateneingang 12 liegt folglich ein Audiosignal an, das aus einer Folge von Abtast- bzw. Audiowerten besteht. Obwohl, wie es aus der folgenden Beschreibung noch deutlich werden wird, die Codierung des Audiosignals nicht blockbasiert stattfindet, werden die Audiowerte am Dateneingang 12 zunächst in einem Schritt 52 zu Audioblöcken zusammengefaßt. Die Zusammenfassung zur Audioblöcken geschieht, wie es aus folgender Beschreibung deutlich wird, lediglich zu Zwecken der Bestimmung der Mithörschwelle und findet in einer Eingangsstufe der Einrichtung 20 zum Ermitteln einer Mithörschwelle statt. Bei dem vorliegenden Ausführungsbeispiel wird exemplarisch davon ausgegangen, daß jeweils 128 aufeinanderfolgende Audiowerte zu Audioblöcken zusammengefaßt werden, und daß die Zusammenfassung derart stattfindet, daß aufeinanderfolgende Audioblöcke sich einerseits nicht überlappen und andererseits unmittelbar benachbart zueinander sind. Dies sei anhand von Fig. 5a noch einmal kurz exemplarisch erläutert.

Fig. 5a zeigt mit 54 die Folge von Abtastwerten an, wobei jeder Abtastwert durch ein Rechteck 56 veranschaulicht ist. Die Abtastwerte sind zu Zwecken der Veranschaulichung numeriert, wobei aus Übersichtlichkeitsgründen wiederum nur einige der Abtastwerte der Folge 54 gezeigt sind. Wie es durch geschweifte Klammern oberhalb der Folge 54 gezeigt ist, sind gemäß vorliegendem Ausführungsbeispiel jeweils 128 aufeinanderfolgende Abtastwerte zu einem Block zusammengefaßt, wobei die unmittelbar darauffolgenden 128 Abtastwerte den nächsten Block bilden. Lediglich vorsichtshalber wird darauf hingewiesen, daß die Zusammenfassung zu Blöcken auch anders vorgenommen werden könnte, beispielsweise durch überlappende Blöcke oder beabstandete Blöcke und Blöcke mit einer anderen Blockgröße, obwohl die Blockgröße von 128 wiederum bevorzugt ist, da sie einen guten Kompromiß zwischen einerseits einer hohen Audioqualität und andererseits einer möglichst niedrigen Verzögerungszeit liefert.

Während die in dem Schritt 52 in der Einrichtung 20 zusammengefaßten Audioblöcke in der Einrichtung 20 zum Ermitteln einer Mithörschwelle blockweise verarbeitet werden, werden in dem Eingangspuffer 32 die eingehenden Audiowerte solange gepuffert bzw. zwischengespeichert 54, bis das parametrisierbare Prefilter 30 von der Stützstellenvergleichseinrichtung 26 Eingangsparameter erhalten hat, um eine Prefilterung vorzunehmen, wie es im folgenden noch beschrieben wird.

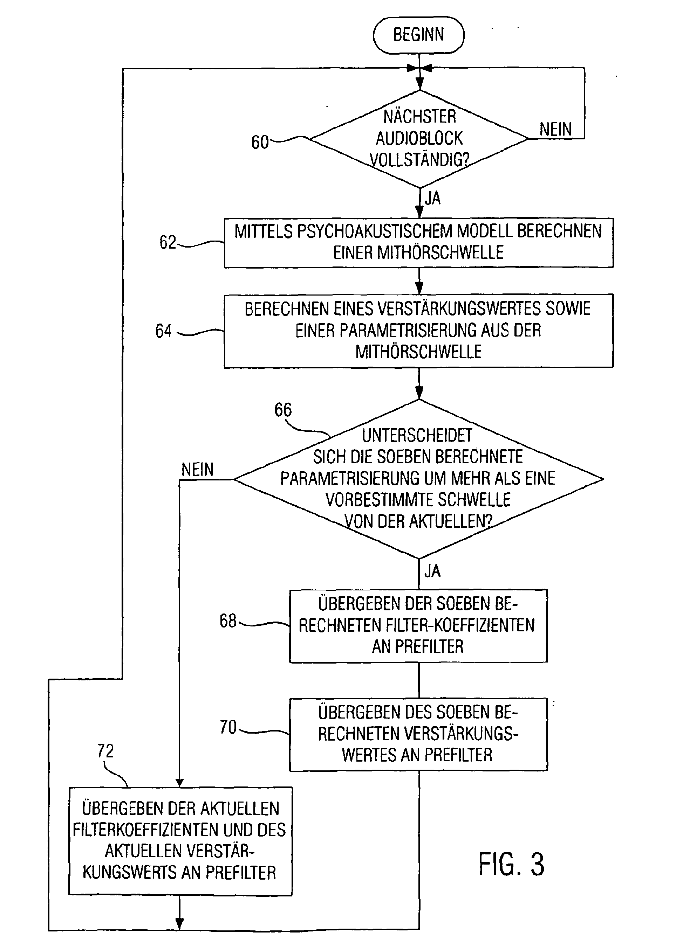

Wie es Fig. 3 zu entnehmen ist, beginnt die Einrichtung 20 zum Ermitteln einer Mithörschwelle ihre Bearbeitung unmittelbar, nachdem genügend Audiowerte am Dateneingang 12 eingegangen sind, um einen Audioblock zu bilden bzw. den nächsten Audioblock zu bilden, was die Einrichtung 20 durch eine Überprüfung in Schritt 60 überwacht. Ist ein bearbeitbarer vollständiger Audioblock noch nicht vorhanden, wartet die Einrichtung 20. Ist ein vollständiger zu bearbeitender Audioblock vorhanden, so berechnet die Einrichtung 20 zum Ermitteln einer Mithörschwelle in einem Schritt 62 auf der Basis eines geeigneten psychoakustischen Modells in einem Schritt 62 eine Mithörschwelle. Zur Veranschaulichung der Mithörschwelle wird wiederum auf Fig. 12 und insbesondere die Kurve b verwiesen, die auf der Grundlage eines psychoakustischen Modells beispielsweise bezüglich eines aktuellen Audioblocks mit einem Spektrum a erhalten worden ist. Die Maskierungsschwelle, die in Schritt 62 ermittelt wird, ist eine frequenzabhängige Funktion, die für aufeinanderfolgende Audioblöcke variieren kann, und auch von Audiosignal zu Audiosignal, wie z.B. von Rock- zu Klassikmusikstücken, deutlich variieren kann. Die Mithörschwelle gibt für jede Frequenz einen Schwellwert an, unterhalb dessen das menschliche Gehör Störungen nicht wahrnehmen kann.

In einem darauffolgenden Schritt 64 berechnen die Einrichtung 24 und die Einrichtung 22 aus der berechneten Mithörschwelle M(f) (wobei f die Frequenz angebe) einen Verstärkungswert a bzw. einen Parametersatz aus N Parametern x(i) (i = 1, ..., N). Die Parametrisierung x(i), die die Einrichtung 24 in Schritt 64 berechnet, ist für das parametrisierbare Prefilter 30 vorgesehen, das beispielsweise in einer Adaptivfilterstruktur ausgeführt ist, wie sie bei der LPC-Codierung verwendet wird (LPC = linear predictive coding = lineare Prädiktionscodierung) ausgeführt. Seien beispielsweise s(n) mit n = 0, ... 127 die 128 Audiowerte des augenblicklichen Audioblocks und s'(n) die sich ergebenden gefilterten 128 Audiowerte, dann ist das Filter beispielsweise derart ausgeführt, daß folgende Gleichung erfüllt ist:

$$s'(n) = s(n) - \sum_{k=1}^{K} a_k^t s(n - k),$$

wobei K die Filterordnung ist und mit k = 1, ..., K die Filterkoeffizienten sind und der Index t veranschaulichen soll, daß sich die Filterkoeffizienten bei aufeinanderfolgenden Audioblöcken ändern. Die Einrichtung 24 berechnet nun die Parametrisierung derart, daß die Übertragungsfunktion H(f) des parametrisierbaren Prefilters 30 in etwa gleich dem Inversen des Betrags der Maskierungsschwelle M(f) ist, d.h. so daß

$$H(f, t) \approx \frac{1}{|M(f, t)|}$$

gilt, wobei die Abhängigkeit von t wiederum veranschaulichen soll, daß für verschiedene Audioblöcke sich die Maskierungsschwelle M(f) ändert. Bei Implementierung des Prefilters 30 als das oben erläuterte adaptive Filter werden die Filterkoeffizienten folgendermaßen erhalten: die inverse diskrete Fourier-Transformation von $|M(f, t)|^2$ über der Frequenz für den Block zum Zeitpunkt t ergibt die Zielautokorrelationsfunktion Dann werden die durch Lösen des linearen Gleichungssystems erhalten:

$$\sum_{k=0}^{K-1} r_{mm}^t(|k - i|) a_k^t = r_{mm}^t(i + 1), \qquad 0 \leq i < K.$$

Damit aber bei der noch im folgenden näher beschriebenen linearen Interpolation zwischen den Parametrisierungen keine Instabilitäten auftreten, wird vorzugsweise für das Filter 30 eine Lattice-Struktur verwendet, wobei die Filterkoeffizienten für die Lattice-Struktur in Reflektionskoeffizienten umparametrisiert werden. Bezüglich näherer Details im Hinblick auf die Ausgestaltung des Prefilters, die Berechnung der Koeffizienten und die Umparametrisierung wird auf den in der Beschreibungseinleitung erwähnten Artikel von Schuller usw. und insbesondere auf Seite 381, Gliederungspunkt III, verwiesen, welcher hiermit diesbezüglich unter Bezugnahme aufgenommen wird.

Während folglich die Einrichtung 24 eine Parametrisierung für das parametrisierbare Prefilter 30 derart berechnet, daß dessen Übertragungsfunktion gleich dem Inversen der Maskierungsschwelle ist, berechnet die Einrichtung 22 basierend auf der Mithörschwelle eine Rauschleistungsgrenze, nämlich eine Grenze, die angibt, welche Rauschleistung der Quantisierer 28 in das durch das Prefilter 30 gefilterte Audiosignal einführen darf, damit das Quantisierungsrauschen nach der Rück- bzw. Postfilterung auf Decoderseite unterhalb der Mithörschwelle M(f) oder genau auf derselben liegt. Die Einrichtung 22 berechnet diese Rauschleistungsgrenze als die Fläche unterhalb des Betragsquadrats der Mithörschwelle M, d.h. als $\Sigma |M(f)|^2$. Den Verstärkungswert a berechnet die Einrichtung 22 aus der Rauschleistungsgrenze, indem sie die Wurzel aus dem Bruch von Quantisierungsrauschleistung durch Rauschleistungsgrenze berechnet. Das Quantisierungsrauschen ist das durch den Quantisierer 28 hervorgerufene Rauschen. Das durch den Quantisierer 28 hervorgerufene Rauschen ist, wie es noch beschrieben werden wird, weißes Rauschen und somit frequenzunabhängig. Die Quantisierungsrauschleistung ist die Leistung des Quantisierungsrauschens.

Wie es aus der vorhergehenden Beschreibung deutlich wurde, berechnet die Einrichtung 22 neben dem Verstärkungswert a auch die Rauschleistungsgrenze. Obwohl es möglich ist, daß die Stützstellenvergleichseinrichtung 26 aus dem von der Einrichtung 22 erhaltenen Verstärkungswert a erneut die Rauschleistungsgrenze berechnet, ist es ferner möglich, daß die Einrichtung 22 neben dem Verstärkungswert a der Stützstellenvergleichseinrichtung 26 auch gleich die ermittelte Rauschleistungsgrenze übermittelt.

Nach der Berechnung des Verstärkungswertes sowie der Parametrisierung überprüft daraufhin die Stützstellenvergleichseinrichtung 26 in einem Schritt 66, ob sich die soeben berechnete Parametrisierung um mehr als eine vorbestimmte Schwelle von der aktuellen, zuletzt an das parametrisierbare Prefilter weitergeleiteten Parametrisierung unterscheidet. Ergibt die Überprüfung in Schritt 66, daß sich die soeben berechnete Parametrisierung um mehr als die vorbestimmte Schwelle von der aktuellen unterscheidet, so werden die soeben berechneten Filterkoeffizienten und der soeben berechnete Verstärkungswert bzw. die Rauschleistungsgrenze in der Stützstellenvergleichseinrichtung 26 für eine noch zu erörternde Interpolation zwischengespeichert und die Stützstellenvergleichseinrichtung 26 übergibt in einem Schritt 68 die soeben berechneten Filterkoeffizienten und in einem Schritt 70 den soeben berechneten Verstärkungswert an das Prefilter 30. Ist dies jedoch nicht der Fall, und die soeben berechnete Parametrisierung unterscheidet sich nicht um mehr als die vorbestimmte Schwelle von der aktuellen, übergibt die Stützstellenvergleichseinrichtung (26) an das Prefilter 30 in Schritt 72 an Stelle der soeben berechneten Parametrisierung nur die aktuelle Stützstellenparametrisierung, d.h. diejenige Parametrisierung, die das letzte Mal im Schritt 66 zu einem positiven Ergebnis führte, sich also um mehr als eine vorbestimmte Schwelle von einer vorhergehenden Stützstellen-Parametrisierung unterschied. Nach den Schritten 70 und 72 kehrt der Prozeß von Fig. 3 zur Bearbeitung des nächsten Audioblocks, d.h. zur Abfrage 60, zurück.

In dem Fall, daß sich die soeben berechnete Parametrisierung nicht von der aktuellen Stützstellen-Parametrisierung unterschied, und demzufolge das Prefilter 30 in Schritt 72 wieder die bereits zuvor für zumindest den letzten Audioblock erhaltene Stützstellenparametrisierung erhält, wendet das Prefilter 30 diese Stützstellenparametrisierung auf alle Abtastwerte dieses sich in dem FIFO 32 befindlichen Audioblocks an, wie es im folgenden noch näher beschrieben wird, wodurch dieser aktuelle Block aus dem FIFO 32 entnommen wird und der Quantisierer 28 einen sich ergebenden Audioblock von pregefilterten Audiowerten erhält.

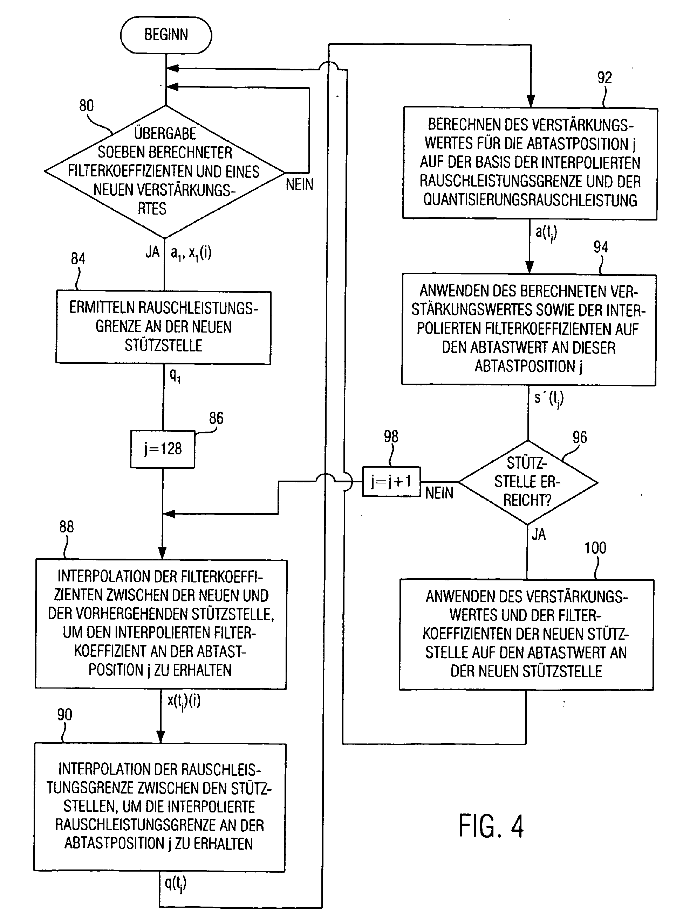

Fig. 4 stellt die Arbeitsweise des parametrisierbaren Prefilters 30 näher für den Fall dar, daß dieselbe die soeben berechnete Parametrisierung und den soeben berechneten Verstärkungswert erhält, weil dieselben sich von der aktuellen Stützstellenparametrisierung ausreichend unterschieden. Wie es Bezug nehmend auf Fig. 3 beschrieben worden ist, erfolgt also nicht zu jedem der aufeinanderfolgenden Audioblöcke eine Verarbeitung nach Fig. 4, sondern nur zu Audioblöcken, bei denen sich die zugehörige Parametrisierung ausreichend von der aktuellen Stützstellenparametrisierung unterschied. Die anderen Audioblöcke werden, wie soeben beschrieben, dadurch pregefiltert, daß die jeweils aktuelle Stützstellenparametrisierung und der zugehörige jeweils aktuelle Verstärkungswert auf alle Abtastwerte dieser Audioblöcke angewendet werden In einem Schritt 80 überwacht nun das parametrisierbare Prefilter 30, ob eine Übergabe von soeben berechneten Filterkoeffizienten von der Stützstellenvergleichseinrichtung 26 stattgefunden hat oder von älteren Stützstellenparametrisierungen. Das Prefilter 30 führt die Überwachung 80 solange durch, bis eine solche Übergabe stattgefunden hat.

Sobald eine solche Übergabe stattgefunden hat, beginnt das parametrisierbare Prefilter 30 mit der Bearbeitung des aktuellen Audioblocks von Audiowerten, der sich gerade in dem Zwischenspeicher 32 befindet, also demjenigen, zu dem die Parametrisierung gerade berechnet worden ist. In Fig. 5a ist beispielsweise veranschaulicht worden, daß alle Audiowerte 56 vor dem Audiowert mit der Nummer 0 bereits verarbeitet worden sind und deshalb den Speicher 32 bereits passiert haben. Die Verarbeitung des Blocks von Audiowerten vor dem Audiowert mit der Nummer 0 ist damals ausgelöst worden, weil die Parametrisierung, die für den Audioblock vor dem Block 0 berechnet worden ist, nämlich $x_0(i)$, sich um mehr als die vorbestimmte Schwelle von der zuvor zum Prefilter 30 weitergeleiteten Stützstellen-Parametrisierung unterschied. Die Parametrisierung $x_0(i)$ ist also eine Stützstellenparametrisierung, wie sie in der vorliegenden Erfindung bezeichnet wird. Die Verarbeitung der Audiowerte in dem Audioblock vor dem Audiowert 0 wurde basierend auf dem Parametersatz $a_0$, $x_0(i)$ durchgeführt.

In Fig. 5a wird davon ausgegangen, daß die Parametrisierung, die zu Block 0 mit den Audiowerten 0 - 127 berechnet worden ist, sich um weniger als die vorbestimmte Schwelle von der Parametrisierung $x_0(i)$ unterschied, die sich auf den Block davor bezog. Dieser Block 0 wurde deshalb ebenfalls bereits von dem Prefilter 30 aus dem FIFO 32 entnommen, hinsichtlich all seiner Abtastwerte 0-127 mittels der in Schritt 72 zugeführten Parametrisierung $x_0(i)$ gleichermaßen verarbeitet, wie es durch den mit "direkte Anwendung" beschriebenen Pfeil 81 angedeutet ist, und dann an den Quantisierer 28 weitergegeben.

Die zu dem sich immer noch in dem FIFO 32 befindlichen Block 1 berechnete Parametrisierung unterschied sich jedoch nach dem exemplarischen Beispiel von Fig. 5a demgegenüber um mehr als die vorbestimmte Schwelle von der Parametrisierung $x_0(i)$ und wurde deshalb in Schritt 68 an das Prefilter 30 als Parametrisierung $x_1(i)$ zusammen mit dem Verstärkungswert $a_1$ (Schritt 70) und gegebenenfalls der zugehörigen Rauschleistungsgrenze weitergeleitet, wobei die Indizes von a und x in Fig. 5a ein Index für die Stützstellen sein sollen, wie sie bei der später zu erörternden Interpolation verwendet werden, die bezüglich der Abtastwerte 128-255 im Block 1 durchgeführt, durch einen Pfeil 82 versinnbildlicht und durch die aus Schritt 80 folgenden Schritte in Fig. 4 verwirklicht wird. Mit Auftreten des Audioblocks mit Nummer 1 würde folglich die Bearbeitung bei Schritt 80 beginnen.

Zur Zeit der Weiterleitung des Parametersatzes $a_1$, $x_1$ befinden sich im Speicher 32 folglich nur noch die Audiowerte 128 - 255, d.h. der aktuelle Audioblock nach dem zuletzt durch das Prefilter 30 verarbeiteten Audioblock 0. Nachdem nun die Übergabe von Stützstellenparametern $x_1(i)$ in Schritt 80 festgestellt worden ist, ermittelt das Prefilter 30 in Schritt 84 die zu dem Verstärkungswert $a_1$ korrespondierende Rauschleistungsgrenze $q_1$. Dies kann dadurch geschehen, daß die Stützstellenvergleichseinrichtung 26 diesen Wert an das Prefilter 30 weiterleitet, oder durch erneute Berechnung dieses Wertes durch das Prefilter 30, wie es im Vorhergehenden Bezug nehmend auf Schritt 64 beschrieben worden ist.

Danach wird in einem Schritt 86 ein Index j auf einen Abtastwert initialisiert, um auf den ältesten in dem FIFO-Speicher 32 verbliebenen Abtastwert bzw. den ersten Abtastwert des aktuellen Audioblocks "Block 1" zu zeigen, d.h. im vorliegenden Beispiel von Fig. 5a den Abtastwert 128. In einem Schritt 88 führt das parametrisierbare Prefilter eine Interpolation zwischen den Filterkoeffizienten $x_0$ und $x_1$ durch, wobei dabei die Parametrisierung $x_0$ als Stützwert an der Stützstelle mit Audiowertnummer 127 des vorhergehenden Blocks 0 und die Parametrisierung $x_1$ als Stützwert an der Stützstelle mit Audiowertnummer 255 des aktuellen Blocks 1 gilt. Diese Audiowertpositionen 127 und 255 werden im folgenden auch als Stützstelle 0 und Stützstelle 1 bezeichnet, wobei in Fig. 5a die sich auf die Stützstellen beziehenden Stützstellenparametrisierungen durch die Pfeile 90 und 92 angedeutet sind.

Das parametrisierbare Prefilter 30 führt in dem Schritt 88 die Interpolation der Filterkoeffizienten $x_0$, $x_1$ zwischen den beiden Stützstellen in Form einer linearen Interpolation durch, um den interpolierten Filterkoeffizienten an der Abtastposition j zu erhalten, d.h. $x(t_j)(i)$ mit $i = 1...N$.

Danach, nämlich in Schritt 90, führt das parametrisierbare Prefilter 30 eine Interpolation zwischen der Rausch-leistungsgrenze $q_1$ und $q_0$ durch, um eine interpolierte Rauschleistungsgrenze an der Abtastposition j zu erhalten, d.h. $q(t_j)$. In einem Schritt 92 berechnet daraufhin das parametrisierbare Prefilter 30 den Verstärkungswert für die Abtastposition j auf der Basis der interpolierten Rauschleistungsgrenze und der Quantisierungsrauschleistung sowie vorzugsweise auch den interpolierten Filterkoeffizienten, nämlich beispielsweise abhängig von der Wurzel aus

$$\frac{\text{Quantisierungsrauschleistung}}{q(t_j)}$$

, wobei hierzu auf die Ausführungen zu Schritt 64 von Fig. 3 verwiesen wird.

In einem Schritt 94 wendet daraufhin das parametrisierbare Prefilter 30 den berechneten Verstärkungswert sowie die interpolierten Filterkoeffizienten auf den Abtastwert an der Abtastposition j an, um einen gefilterten Abtastwert für diese Abtastposition zu erhalten, nämlich $s'(t_j)$.

In einem Schritt 96 überprüft das parametrisierbare Prefilter 30 daraufhin, ob die Abtastposition j die aktuelle Stützstelle, d.h. Stützstelle 1, erreicht hat, in dem Fall von Fig. 5a die Abtastposition 255, d.h. den Abtastwert, für den die dem parametrisierbaren Prefilter 30 übermittelte Parametrisierung plus Verstärkungswert unmittelbar, d.h. ohne Interpolation, gelten soll. Ist dies nicht der Fall, so erhöht bzw. inkrementiert das parametrisierbare Prefilter 30 den Index j um 1, wobei die Schritte 88 - 96 erneut wiederholt werden. Fällt die Überprüfung im Schritt 96 jedoch positiv aus, so wendet in Schritt 100 das parametrisierbare Prefilter den von der Stützstellenvergleichseinrichtung 26 zuletzt übermittelten Verstärkungswert und die von der Stützstellenvergleichseinrichtung 26 zuletzt übermittelten Filterkoeffizienten unmittelbar ohne Interpolation auf den Abtastwert an der neuen Stützstelle an, woraufhin der aktuelle Block, d.h. in dem vorliegenden Fall der Block 1, abgearbeitet ist, und der Prozeß von neuem bei Schritt 80 bezüglich des nachfolgenden zu verarbeitenden Blocks durchgeführt wird, der je nach dem, ob sich die Parametrisierung des nächsten Audioblocks Block 2 ausreichend von der Parametrisierung $x_1(i)$ unterscheidet, gegebenenfalls eben dieser nächste Audioblock Block 2 sein kann oder aber ein späterer Audioblock ist.

Bevor Bezug nehmend auf Fig. 5 das weitere Vorgehen bei der Verarbeitung der gefilterten Abtastwerte s' beschrieben wird, wird im folgenden Zweck und Hintergrund der Vorgehensweise nach den Fig. 3 und 4 beschrieben. Sinn und Zweck der Filterung besteht darin, das Audiosignal am Eingang 12 mit einem adaptiven Filter zu filtern, dessen Übertragungsfunktion ständig möglichst optimal an das Inverse der Mithörschwelle angepaßt ist, die sich ja ebenfalls in der Zeit ändert. Der Grund hierfür besteht darin, daß decoderseitig die Rückfilterung durch ein adaptives Filter, dessen Übertragungsfunktion dementsprechend ständig an die Mithörschwelle angepaßt ist, das durch eine Quantisierung des gefilterten Audiosignals eingeführte weiße Quantisierungsrauschen, d.h. das in der Frequenz konstante Quantisierungsrauschen, formt, nämlich an die Form der Mithörschwelle anpaßt.

Die Anwendung des Verstärkungswertes in den Schritten 94 und 100 im Prefilter 30 besteht in einer Multiplikation des Audiosignals bzw. des gefilterten Audiosignals, d.h. der Abtastwerte s oder der gefilterten Abtastwerte s', mit dem Verstärkungsfaktor. Der Sinn besteht darin, hierdurch das Quantisierungsrauschen, das durch die anschließend näher beschriebene Quantisierung in das gefilterte Audiosignal eingefügt wird, und das durch die Rückfilterung decoderseitig an die Form der Mithörschwelle angepaßt wird, möglichst so hoch einzustellen, daß es die Mithörschwelle dennoch nicht überschreitet. Veranschaulichend läßt sich dies durch die Parseval'sche Formel, nach welcher das Betragsquadrat einer Funktion gleich dem Betragsquadrat der FourierTransformierten ist. Wenn also decoderseitig die Multiplikation des Audiosignals im Prefilter mit dem Verstärkungswert wieder rückgängig gemacht wird, indem das gefilterte Audiosignal mit dem Verstärkungswert dividiert wird, reduziert sich damit die Quantisierungsrauschleistung ebenfalls, nämlich um den Faktor $a^{-2}$, wobei a der Verstärkungswert ist. Folglich kann durch die Anwendung des Verstärkungswertes in dem Prefilter 30 die Quantisierungsrauschleistung optimal hoch eingestellt werden, was gleichbedeutend damit ist, daß die Quantisierungsschrittweite erhöht und damit die Anzahl der zu codierenden Quantisierungsstufen reduziert wird, was wiederum die Kompression in dem anschließenden Redundanzreduktionsteil erhöht.

Anders ausgedrückt, kann der Effekt des Prefilters als eine Normierung des Signals an seine Maskierungsschwelle angesehen werden, so daß der Pegel der Quantisierungsstörungen bzw. des Quantisierungsrauschens sowohl in Zeit auch Frequenz konstant gehalten werden kann. Da das Audiosignal im Zeitbereich vorliegt, kann deshalb die Quantisierung mit einer gleichmäßigen konstanten Quantisierung schrittweise durchgeführt werden, wie es im folgenden noch beschrieben wird. Auf diese Weise wird idealerweise jegliche Irrelevanz aus dem Audiosignal entfernt, und es kann ein verlustfreies Kompressionsschema verwendet werden, um auch noch die verbleibende Redundanz in dem pregefilterten und quantisierten Audiosignal zu entfernen, wie es im folgenden noch beschrieben wird.

Anhand von Fig. 5a soll ferner noch einmal deutlich hervorgehoben werden, daß freilich die verwendeten Filterkoeffizienten und Verstärkungswerte $a_0$, $a_1$, $x_0$, $x_1$ als Seiteninformationen decoderseitig zur Verfügung stehen müssen, daß aber der Übertragungsaufwand hierzu dadurch verringert wird, daß neue Filterkoeffizienten und neue Verstärkungswerte nicht einfach für jeden Block neu verwendet werden. Vielmehr findet eine Schwellwertüberprüfung 66 statt, um nur bei ausreichender Parametrisierungsänderung die Parametrisierungen als Seiteninformationen zu übertragen, und ansonsten werden die Seiteninformationen bzw. Parametrisierungen nicht übertragen. An den Audioblöcken, für die die Parametrisierungen übertragen wurden, findet über den Bereich dieser Blöcke eine Interpolation von der alten zu der neuen Parametrisierung statt. Die Interpolation der Filterkoeffizienten findet auf die im Vorhergehenden Bezug nehmend auf den Schritt 88 beschriebene Weise statt. Die Interpolation im Hinblick auf die Verstärkung findet über einen Umweg statt, nämlich über eine lineare Interpolation 90 der Rauschleistungsgrenze $q_0$, $q_1$. Im Vergleich zu einer unmittelbaren Interpolation über den Verstärkungswert führt die lineare Interpolation bezüglich der Rauschleistungsgrenze zu einem besseren Hörergebnis bzw. weniger hörbaren Artefakten.

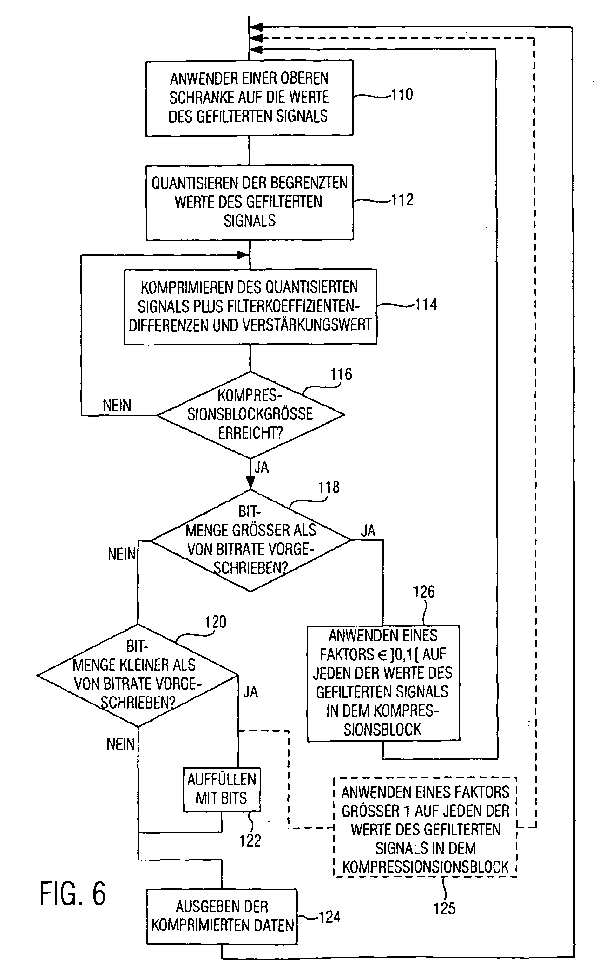

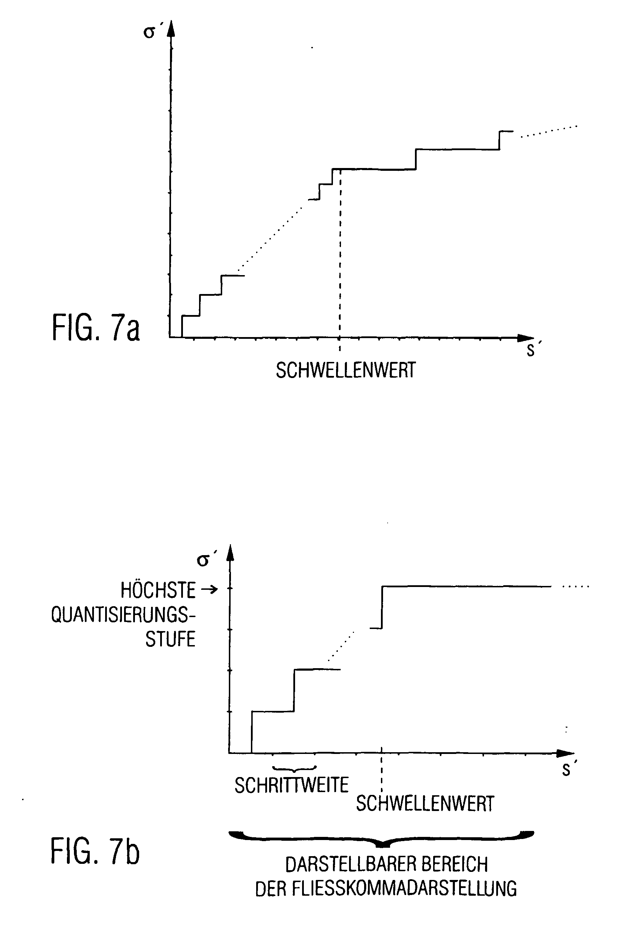

Im folgenden wird nun anhand von Fig. 6 die weitere Verarbeitung des pre- bzw. vorgefilterten Signals beschrieben, welche im wesentlichen eine Quantisierung und eine Redundanzreduktion umfaßt. Zunächst werden die von dem parametrisierbaren Prefilter 30 ausgegebenen gefilterten Abtastwerte in dem Buffer 38 gespeichert und gleichzeitig von dem Buffer 38 zu dem Multiplizierer 40 durchgelassen, wo sie wiederum, da es ihr erster Durchlauf ist, zunächst unverändert, nämlich mit einem Skalierungsfaktor von Eins, durch den Multiplizierer 40 an den Quantisierer 28 weitergegeben werden. Dort werden die gefilterten Audiowerte oberhalb einer oberen Schranke in einem Schritt 110 abgeschnitten und daraufhin in einem Schritt 112 quantisiert. Die beiden Schritte 110 und 112 werden von dem Quantisierer 28 ausgeführt. Insbesondere werden die beiden Schritte 110 und 112 von dem Quantisierer 28 bevorzugter Weise in einem Schritt ausgeführt, indem die gefilterten Audiowerte s' mit einer Quantisierungsstufenfunktion quantisiert werden, die die beispielsweise in einer Fließkommadarstellung vorliegenden gefilterten Abtastwerte s' auf eine Mehrzahl von ganzzahligen Quantisierungsstufenwerten bzw. -indizes abbildet und ab einem gewissen Schwellwert für die gefilterten Abtastwerte flach verläuft, so daß gefilterte Abtastwerte, die größer als der Schwellwert sind, auf ein und dieselbe Quantisierungsstufe quantisiert werden. Ein Beispiel für eine solche Quantisierungsstufenfunktion ist in Fig. 7a dargestellt.

Die quantisierten gefilterten Abtastwerte sind in Fig. 7a mit σ' bezeichnet. Die Quantisierungsstufenfunktion ist vorzugsweise eine Quantisierungsstufenfunktion mit unterhalb des Schwellwertes konstanter Schrittweite, d.h. der Sprung auf die nächste Quantisierungsstufe findet stets nach einem konstanten Intervall entlang der Eingangswerte S' statt. In der Implementierung wird die Schrittweite zum Schwellwert derart eingestellt, daß die Anzahl an Quantisierungsstufen vorzugsweise einer Potenz von 2 entspricht. Im Vergleich zur Fließkommadarstellung der eingehenden gefilterten Abtastwerte s' ist der Schwellwert kleiner, so daß ein Maximalwert des darstellbaren Bereichs der Fließkommadarstellung den Schwellwert übertrifft.

Der Grund für den Schwellwert besteht darin, daß beobachtet worden ist, daß das gefilterte Audiosignal, das von dem Prefilter 30 ausgegeben wird, vereinzelt Audiowerte aufweist, die sich aufgrund einer ungünstigen Akkumulation von Oberwellen zu sehr großen Werten aufsummieren. Ferner ist beobachtet worden, daß ein Abschneiden dieser Werte, wie es durch die in Fig. 7a gezeigte Quantisierungsstufenfunktion erzielt wird, zu einer hohen Datenreduktion, aber nur zu einer geringfügigen Beeinträchtigung der Audioqualität führt. Vielmehr entstehen diese vereinzelten Stellen im gefilterten Audiosignal künstlich durch die frequenzselektive Filterung im parametrisierbaren Filter 30, so daß ein Abschneiden derselben die Audioqualität nur geringfügig beeinträchtigt.

Ein etwas konkreteres Beispiel für die in Fig. 7a gezeigte Quantisierungsstufenfunktion wäre eine solche, die bis zum Schwellwert alle gefilterten Abtastwerte s' auf die nächstgelegene Ganzzahl rundet, und von da an alle darüberliegenden gefilterten Abtastwerte auf die höchste Quantisierungsstufe quantisiert, wie z.B. 256. Dieser Fall ist in Fig. 7a dargestellt.

Ein weiteres Beispiel für eine mögliche Quantisierungsstufenfunktion wäre die in Fig. 7b gezeigte. Bis zum Schwellwert entspricht die Quantisierungsstufenfunktion von Fig. 7b derjenigen von Fig. 7a. Anstatt jedoch für Abtastwerte s' oberhalb des Schwellwertes abrupt flach zu verlaufen, verläuft die Quantisierungsstufenfunktion mit einer Steilheit weiter, die kleiner ist als die Steilheit im Bereich unterhalb des Schwellwertes. Anders ausgedrückt ist oberhalb des Schwellwertes die Quantisierungsschrittweite größer. Hierdurch wird ein ähnlicher Effekt erzielt wie mit der Quantisierungsfunktion von Fig. 7a, jedoch mit einerseits mehr Aufwand aufgrund der verschiedenen Schrittweiten der Quantisierungsstufenfunktion oberhalb und unterhalb des Schwellwertes und andererseits einer besserten Audioqualität, da sehr hohe gefilterte Audiowerte s' nicht vollständig abgeschnitten werden, sondern lediglich mit einer größeren Quantisierungsschrittweite quantisiert werden.

Wie es im Vorhergehenden schon beschrieben worden ist, müssen decoderseitig nicht nur die quantisierten und gefilterten Audiowerte σ' zur Verfügung stehen, sondern ferner auch die Eingangsparameter für das Prefilter 30, die der Filterung dieser Werte zugrundegelegt worden sind, nämlich die Stützstellenparametrisierung inklusive eines Hinweises auf den zugehörigen Verstärkungswert. In einem Schritt 114 unternimmt deshalb der Komprimierer 34 einen ersten Komprimierungsversuch und komprimiert dabei Seiteninformationen beinhaltend die Verstärkungswerte $a_0$ und $a_1$ an den Stützstellen, wie z.B. 127 und 255, sowie die Filterkoeffizienten $x_0$ und $x_1$ an den Stützstellen und die quantisierten, gefilterten Abtastwerte σ' in ein vorläufiges gefiltertes Signal. Der Komprimierer 34 ist dabei ein verlustfrei arbeitender Codierer, wie z.B. ein Huffman- oder arithmetischer Codierer mit oder ohne Prädiktion und/oder Adaption.

Der Speicher 38, den die abgetasteten Audiowerte σ' durchlaufen, dient als Zwischenspeicher für eine geeignete Blockgröße, mit welcher der Komprimierer 34 die von dem Quantisierer 28 ausgegebenen quantisierten, gefilterten und, wie im folgenden beschriebenen gegebenenfalls skalierten, Audiowerte σ' verarbeitet. Die Blockgröße kann sich von der Blockgröße der Audioblöcke, wie sie von der Einrichtung 20 verwendet werden, unterscheiden.

Wie bereits erwähnt hat für den ersten Komprimierungsversuch die Bitratensteuerung 36 den Multiplizierer 40 mit einem Multiplikator von 1 angesteuert, so daß die gefilterten Audiowerte von dem Prefilter 30 unverändert zu dem Quantisierer 28 und von dort aus als quantisierte, gefilterte Audiowerte zu dem Komprimierer 34 gelangen. Der Komprimierer 34 überwacht in einem Schritt 116, ob eine gewisse Kompressionsblockgröße, d.h. eine gewisse Anzahl von quantisierten, abgetasteten Audiowerten, in das vorläufige codierte Signal codiert worden ist, oder ob weitere quantisierte, gefilterte Audiowerte σ' in das aktuelle vorläufige codierte Signal zu codieren sind. Ist die Kompressionsblockgröße nicht erreicht, führt der Komprimierer 34 die aktuelle Kompression 114 weiter durch. Ist die Kompressionsblockgröße jedoch erreicht, überprüft in einem Schritt 118 die Bitratensteuerung 36, ob die für die Komprimierung benötigte Bitmenge größer als eine von einer erwünschten Bitrate vorgeschriebene Bitmenge ist. Ist dies nicht der Fall, überprüft die Bitratensteuerung 36 in einem Schritt 120, ob die benötigte Bitmenge kleiner als die durch die erwünschte Bitrate vorgeschriebene Bitmenge ist. Ist dies der Fall, fügt die Bitratensteuerung 36 das codierte Signal in Schritt 122 mit Füllbits auf, bis die durch die erwünschte Bitrate vorgeschriebene Bitmenge erreicht ist. Anschließend erfolgt in Schritt 124 die Ausgabe des codierten Signals. Alternativ zu Schritt 122 könnte die Bitratensteuerung 36 den in dem Speicher 38 noch gespeicherten, zuletzt der Kompression zugrundeliegenden Kompressionsblock von gefilterten Audiowerten σ' in mit einem Multiplikator größer 1 durch den Multiplizierer 40 multiplizierter Form an den Quantisierer 28 zum erneuten Durchlaufen der Schritte 110 - 118 weiterleiten, bis die durch die erwünschte Bitrate vorgeschriebene Bitmenge erreicht ist, wie es durch einen gestrichelten Schritt 125 angezeigt ist.

Ergibt jedoch die Überprüfung in Schritt 118, daß die benötigte Bitmenge größer als die von der erwünschten Bitrate vorgeschriebene ist, ändert die Bitratensteuerung 36 den Multiplikator für den Multiplizierer 40 auf einen Faktor zwischen 0 und 1 ausschließlich. Dies führt sie in Schritt 126 durch. Nach dem Schritt 126 sorgt die Bitratensteuerung 36 dafür, daß der Speicher 38 den letzten der Kompression zugrundeliegenden Kompressionsblock von gefilterten Audiowerten σ' erneut ausgibt, wobei dieselben daraufhin mit dem in Schritt 126 eingestellten Faktor multipliziert werden und erneut dem Quantisierer 28 zugeführt werden, woraufhin die Schritte 110 - 118 erneut durchgeführt werden und das bisher vorläufig kodierte Signal verworfen wird.

Es wird darauf hingewiesen, daß bei erneutem Durchführen der Schritte 110 - 116 in dem Schritt 114 freilich auch der in dem Schritt 126 (oder dem Schritt 125) verwendete Faktor in das codierte Signal eingebunden wird.

Der Sinn der Vorgehensweise nach Schritt 126 besteht darin, daß durch den Faktor die effektive Schrittweite des Quantisierers 28 erhöht wird. Dies bedeutet, daß das resultierende Quantisierungsrauschen gleichmäßig oberhalb der Maskierungsschwelle liegt, was zu hörbaren Störungen bzw. hörbarem Rauschen führt, aber dafür eine reduzierte Bitrate ergibt. Wird nach erneutem Durchlaufen der Schritte 110 - 116 in Schritt 118 erneut festgestellt, daß die benötigte Bitmenge größer als die von der gewünschten Bitrate vorgeschriebene ist, wird der Faktor in Schritt 126 weiter reduziert usw.

Wenn die Daten schließlich bei Schritt 124 als codiertes Signal ausgegeben werden, wird der nächste Kompressionsblock von den darauffolgenden quantisierten, gefilterten Audiowerten σ' durchgeführt.

Es wird noch darauf hingewiesen, dass auch ein anderer vorinitialisierte Wert für den Multiplikationsfaktor verwendet werden könnte als 1, nämlich beispielsweise 1. Dann fände auf jeden Fall, also ganz oben in Fig. 6, vorab eine Skalierung statt.

Fig. 5b veranschaulicht noch einmal das sich ergebende codierte Signal, das allgemein mit 130 angezeigt ist. Das codierte Signal umfaßt Seiteninformationen und dazwischenliegende Hauptdaten. Die Seiteninformationen umfassen, wie bereits erwähnt, Informationen, aus denen für spezielle Audioblöcke, nämlich Audioblöcke, bei denen sich in der Folge von Audioblöcken eine signifikante Änderung in den Filterkoeffizienten ergeben hat, der Wert des Verstärkungswertes und der Wert der Filterkoeffizienten hergeleitet werden kann. Gegebenenfalls umfassen die Seiteninformationen ferner weitere Informationen, die sich auf den für die Bitsteuerung verwendeten Verstärkungswert beziehen. Aufgrund der gegenseitigen Abhängigkeit zwischen Verstärkungswert und Rauschleistungsgrenze q können die Seiteninformationen wahlweise neben dem Verstärkungswert $a_\#$ zu einer Stützstelle # auch die Rauschleistungsgrenze $q_\#$ umfassen, oder auch nur letztere. Innerhalb des codierten Signals sind die Seiteninformationen vorzugsweise derart angeordnet, daß die Seiteninformationen zu Filterkoeffizienten und zugehörigem Verstärkungswert bzw. zugehöriger Rauschleistungsgrenze vor den Hauptdaten zu dem Audioblock von quantisierten, gefilterten Audiowerten σ' angeordnet sind, aus dem diese Filterkoeffizienten mit zugehörigem Verstärkungswert bzw. zugehöriger Rauschleistungsgrenze abgeleitet worden sind, also die Seiteninformationen $a_0$, $x_0(i)$ nach dem Block -1 und die Seiteninformationen $a_1$, $x_1(i)$ nach dem Block 1. Anders ausgedrückt sind die Hauptdaten, d.h. die quantisierten, gefilterten Audiowerte σ', ab exklusive einem Audioblock der Art, bei der sich eine in der Folge von Audioblöcken signifikante Änderung in den Filterkoeffizienten ergeben hat, bis zu einschießlich dem nächsten Audioblock dieser Art, in Fig. 5b beispielsweise die Audiowerte σ' ($t_0$) - σ' ($t_{255}$), immer zwischen dem Seiteninformationsblock 132 zu dem ersteren dieser beiden Audioblöcke (Block -1) und dem weiteren Seiteninformationsblock 134 zu dem zweiten dieser beiden Audioblöcke (Block 1) angeordnet.. Die Audiowerte σ' ($t_0$) - σ' ($t_{127}$) sind wie im vorhergehenden bezugnehmend auf Fig. 5a erwähnt allein mittels der Seiteninformationen 132 erhalten worden bzw. dekodierbar, während die Audiowerte σ' ($t_{128}$) - σ' ($t_{255}$) durch Interpolation mittels der Seiteninformationen 132 als Stützwerte an der Stützstelle mit der Abtastwertnummer 127 und mittels der Seiteninformationen 134 als Stützwerte an der Stützstelle mit der Abtastwertnummer 255 erhalten worden sind und somit nur mitels beider Seiteninformationen dekodierbar sind.

Ferner werden die Seiteninformationen betreffend den Verstärkungswert bzw. die Rauschleistungsgrenze und die Filterkoeffizienten in jedem Seiteninformationsblock 132 und 134 nicht immer unabhängig voneinander eingebunden. Vielmehr werden diese Seiteninformationen in Differenzen zu dem vorhergehenden Seiteninformationsblock übertragen. In Fig. 5b enthält beispielsweise der Seiteninformationsblock 132 Verstärkungswert $a_0$ und Filterkoeffizienten $x_0$ bezüglich der Stützstelle zum Zeitpunkt $t_{-1}$. In dem Seiteninformationsblock 132 sind diese Werte aus dem Block selbst herleitbar. Aus dem Seiteninformationsblock 134 sind jedoch die Seiteninformationen betreffend die Stützstelle zum Zeitpunkt $t_{255}$ nicht mehr aus diesem Block allein herleitbar. Vielmehr umfaßt der Seiteninformationsblock 134 lediglich Informationen über Differenzen des Verstärkungswertes $a_1$ der Stützstelle zum Zeitpunkt $t_{255}$ zu dem Verstärkungswert der Stützstelle zum Zeitpunkt $t_0$ und die Differenzen der Filterkoeffizienten $x_1$ zu den Filterkoeffizienten $x_0$. Der Seiteninformationsblock 134 enthält folglich lediglich die Informationen zu $a_1 - a_0$ und $x_1(i) - x_0(i)$. Zu intermittierenden Zeitpunkten sollten jedoch die Filterkoeffizienten und der Verstärkungswert bzw. die Rauschleistungsgrenze voll und nicht nur als Differenz zur vorhergehenden Stützstelle übertragen werden, wue z.B. jede Sekunde, um einem Empfänger bzw. Dekodierer das einklinken in einen laufenden Strom von Codierungsdaten zu ermöglichen, wie es im folgenden noch erörtert wird.

Diese Art des Einbindens der Seiteninformationen in die Seiteninformationsblöcke 132 und 134 bietet den Vorteil der Möglichkeit einer höheren Komprimierungsrate. Der Grund dafür besteht darin, daß, obwohl die Seiteninformationen möglichst nur dann übertragen werden, wenn sich eine ausreichende Änderung der Filterkoeffizienten zu den Filterkoeffizienten einer vorhergehenden Stützstelle ergeben hat, sich der Aufwand der Differenzbildung codiererseitig bzw. Summenbildung decodierseitig lohnt, da die sich ergebenden Differenzen trotz der Abfrage in Schritt 66 klein sind, um somit Vorteile bei der Entropiecodierung zu ermöglichen.

Nachdem im Vorhergehenden ein Ausführungsbeispiel für einen Audiocodierer beschrieben worden ist, wird im folgenden ein Ausführungsbeispiel für einen Audiodecodierer beschrieben, der geeignet ist, das durch den Audiocodierer 10 von Fig. 1 erzeugte codierte Signal in ein decodiertes, abspielbares bzw. weiterverarbeitbares Audiosignal zu decodieren.

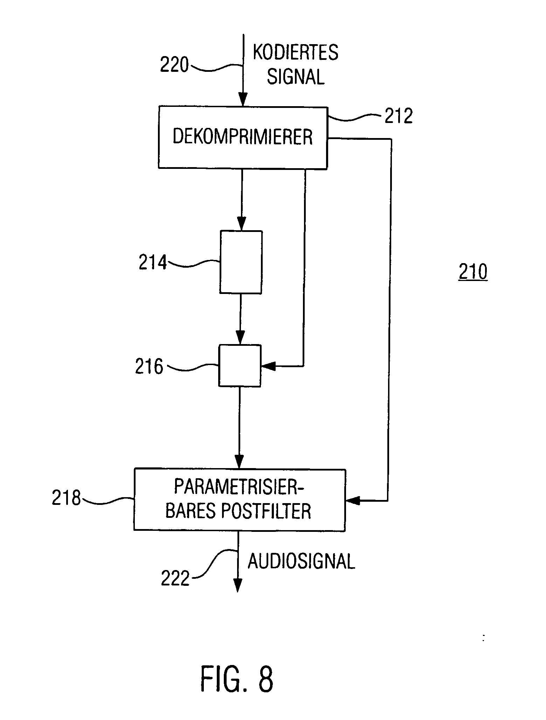

Der Aufbau dieses Decodierers ist in Fig. 8 gezeigt. Der Decodierer, der allgemein mit 210 angezeigt ist, umfaßt einen Dekomprimierer 212, einen FIFO-Speicher 214, einen Multiplizierer 216 und ein parametrisierbares Postfilter 218. Dekomprimierer 212, FIFO-Speicher 214, Multiplizierer 216 und parametrisierbares Postfilter 218 sind in dieser Reihenfolge zwischen einen Dateneingang 220 und einen Datenausgang 222 des Decodierers 210 geschaltet, wobei am Dateneingang 220 das codierte Signal erhalten wird und am Datenausgang 222 das decodierte Audiosignal ausgegeben wird, das sich lediglich durch das durch den Quantisierer 28 im Audiocodierer 10 erzeugte Quantisierungsrauschen von dem ursprünglichen Audiosignal am Dateneingang 12 des Audiocodierers 10 unterscheidet. Der Dekomprimierer 212 ist an einem weiteren Datenausgang mit einem Steuereingang des Multiplizierers 216 verbunden, um an denselben einen Multiplikator weiterzuleiten, und über einen weiteren Datenausgang mit einem Parametrisierungseingang des parametrisierbaren Postfilters 218.

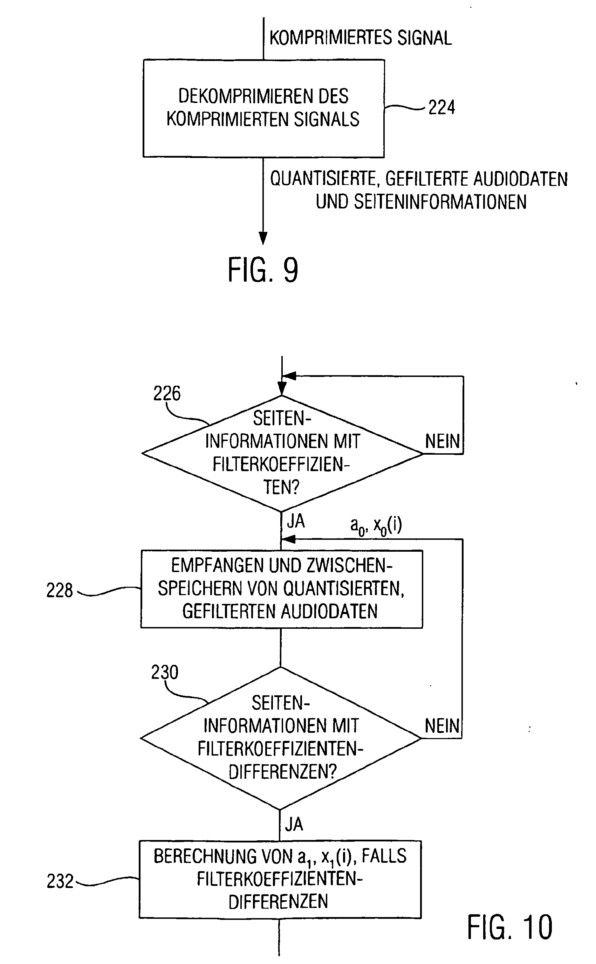

Wie es in Fig. 9 gezeigt ist, dekomprimiert der Dekomprimierer 212 in einem Schritt 224 zunächst das am Dateneingang 220 anliegende komprimierte Signal, um an die quantisierten, gefilterten Audiodaten, nämlich die Abtastwerte σ', sowie die dazugehörigen Seiteninformationen in den Seiteninformationsblöcken 132, 134 zu gelangen, die ja die Filterkoeffizienten und Verstärkungswerte oder, anstelle der Verstärkungswerte, die Rauschleistungsgrenzen, an den Stützstellen anzeigen.

Wie es in Fig. 10 gezeigt ist, überprüft der Dekomprimierer 212 in einem Schritt 226 das dekomprimierte Signal in der Reihenfolge seiner Ankunft, ob darin Seiteninformationen mit Filterkoeffizienten enthalten sind, und zwar in in sich abgeschlossener Form ohne Differenzbezugnahme auf einen vorhergehenden Seiteninformationsblock. Anders ausgedrückt, sucht der Dekomprimierer 212 nach dem ersten Seiteninformationsblock 132. Sobald der Dekomprimierer 212 fündig geworden ist, werden die quantisierten, gefilterten Audiowerte σ' in einem Schritt 228 in dem FIFO-Speicher 214 zwischengespeichert. Ist während des Schrittes 228 ein vollständiger Audioblock von quantisierten, gefilterten Audiowerte σ' eingespeichert worden, ohne daß unmittelbar ein Seiteninformationsblock folgt, so wird dieser innerhalb des Schrittes 228 zunächst mittels der in in dem Schritt 226 empfangenen Seiteninformationen enthaltenen Informationen über Parametrisierung und Verstärkungswert in dem Postfilter postgefiltert und im Multiplizierer 216 verstärkt, wodurch er dekodiert und damit der zugehörige dekodierte Audioblock erhalten wird.

In einem Schritt 230 überwacht der Dekomprimierer 212 das dekomprimierte Signal auf das Auftauchen eines irgendwie gearteten Seiteninformationsblocks, nämlich mit absoluten Filterkoeffizienten oder Filterkoeffizienten-Differenzen zu einem vorhergehenden Seiteninformationsblock hin. In dem Beispiel von Fig. 5b würde beispielsweise der Dekomprimierer 212 auf die Erkennung des Seiteninformationsblocks 132 im Schritt 226 in dem Schritt 230 das Auftauchen des Seiteninformationsblocks 134 erkennen. Dabei wäre bereits in Schritt 228 der Block von quantisierten, gefilterten Audiowerten σ' $(t_0)$ - σ' $(t_{127})$ dekodiert worden, und zwar unter Verwendung der Seiteninformationen 132. Solange der Seiteninformationsblock 134 im dekomprimierten Signal also noch nicht auftritt, wird die Zwischenspeicherung und die eventuelle Dekodierung von Blöcken vermittels der Seiteninformationen aus Schritt 226, wie es im vorhergehenden beschrieben wurde, im Schritt 228 fortgesetzt.

Sobald der Seiteninformationsblock 134 auftritt, berechnet der Dekomprimierer 212 im Schritt 232 durch Summieren der Differenzwerte in dem Seiteninformationsblock 134 zu den Parameterwerten in dem Seiteninformationsblock 132 die Parameterwerte an der Stützstelle 1, d.h. $a_1$, $x_1(i)$. Freilich entfällt der Schritt 232 falls der aktuelle Seiteninformationsblock ein in sich abgeschlossener Seiteninformationsblock ohne Differenzen ist, was, wie im vorhergehenden beschrieben beispielsweise alle Sekunde der Fall sein kann.Damit die Wartezeit für den Decodierer 210 nicht zu lange ist, werden Seiteninformationsblöcke 132, bei denen die Parameterwerte absolut, d.h. ohne Relation zu einem anderen Seiteninformationsblock, herleitbar sind, in genügend kleinen Abständen angeordnet, so daß die Einschaltzeit bzw. die Totzeit beim Einschalten des Audiocodierers 210 bei beispielsweise einer Funkübertragung oder Rundfunkübertragung nicht zu groß ist. Vorzugsweise sind auch die Anzahl der dazwischen angeordneten Seiteninformationsblöcke 134 mit den Differenzwerten in einer festen vorbestimmten Anzahl zwischen den Seiteninformationsblöcken 132 angeordnet, so daß der Decodierer weiß, wann wieder ein Seiteninformationsblock der Art 132 in dem codierten Signal zu erwarten ist. Alternativ werden die verschiedenen Seiteninformationsblocktypen durch entsprechende Flags angezeigt.

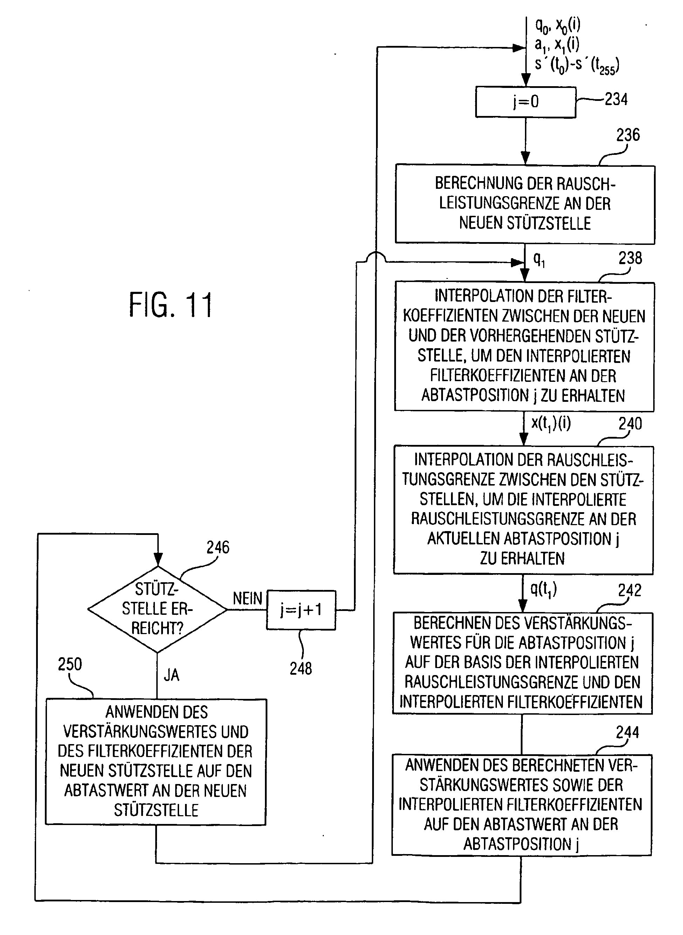

Wie es nun in Fig. 11 gezeigt ist, wird, nachdem nun ein Seiteninformationsblock für eine neue Stützstelle erreicht worden ist, und zwar insbesonder nach Schritt 226 oder 232, zunächst ein Abtastwertindex j auf 0 im Schritt 234 initialisiert. Dieser Wert entspricht der Abtastposition des ersten Abtastwertes in dem aktuell in dem FIFO 214 verbliebenen Audioblock, auf den sich die aktuellen Seiteninformationen beziehen. Schritt 234 wird von dem parametrisierbaren Postfilter 218 durchgeführt. Das Postfilter 218 führt danach in einem Schritt 236 eine Berechnung der Rauschleistungsgrenze an der neuen Stützstelle durch, wobei dieser Schritt dem Schritt 84 von Fig. 4 entspricht und gegebenenfalls entfallen kann, wenn beispielsweise die Rauchleistungsgrenze an den Stützstellen zusätzlich zu den Verstärkungswerten übertragen wird. In nachfolgenden Schritten 238 und 240 führt daraufhin das Postfilter 218 Interpolationen bezüglich der Filterkoeffizienten und der Rauschleistungsgrenzen durch, die den Interpolationen 88 und 90 von Fig. 4 entsprechen. Die nachfolgende Berechnung des Verstärkungswertes für die Abtastposition j auf der Basis der interpolierten Rauschleistungsgrenze und den interpolierten Filterkoeffizienten aus den Schritten 238 und 240 in Schritt 242 entspricht dem Schritt 92 von Fig. 4. In einem Schritt 244 wendet daraufhin das Postfilter 218 den in Schritt 242 berechneten Verstärkungswert sowie die interpolierten Filterkoeffizienten auf den Abtastwert an der Abtastposition j an. Dieser Schritt unterscheidet sich von dem Schritt 94 von Fig. 4 dadurch, daß die interpolierten Filterkoeffizienten derart auf die quantisierten, gefilterten Abtastwerte σ' angewendet werden, daß die Übertragungsfunktion des parametrisierbaren Postfilters nicht dem Inversen der Mithörschwelle, sondern der Mithörschwelle selbst entspricht. Ferner führt das Postfilter nicht eine Multiplikation mit dem Verstärkungswert, sondern eine Division durch den Verstärkungswert an dem quantisierten, gefilterten Abtastwert σ' oder bereits zurückgefilterten, quantisierten, gefilterten Abtastwert an der Position j durch.

Hat das Postfilter 218 noch nicht die aktuelle Stützstelle mit der Abtastposition j erreicht, was dasselbe in Schritt 246 überprüft, inkrementiert es in Schritt 248 den Abtastpositionsindex j und beginnt die Schritte 238 - 246 von neuem. Erst wenn die Stützstelle erreicht ist, wendet sie den Verstärkungswert und die Filterkoeffizienten der neuen Stützstelle auf den Abtastwert an der Stützstelle an, nämlich in Schritt 250. Wiederum umfaßt die Anwendung wie im Schritt 218 anstatt einer Multiplikation eine Division mittels des Verstärkungswertes und eine Filterung mit einer Übertragungsfunktion gleich der Mithörschwelle und nicht dem Inversen letztgenannter. Nach Schritt 250 ist der aktuelle Audioblock durch Interpolation zwischen zwei Stützstellenparametrisierungen dekodiert.

Wie bereits erwähnt, wird durch die Filterung und die Anwendung des Verstärkungswertes in den Schritten 218 und 224 das durch die Quantisierung bei der Codierung in Schritt 110 bzw. 112 eingefügte Rauschen sowohl in Form als auch in Höhe an die Mithörschwelle angepaßt.

Es wird noch darauf hingewiesen, daß in dem Fall, daß die quantisierten, gefilterten Audiowerte aufgrund der Bitratensteuerung vor der Codierung in das codierte Signal noch einer weiteren Multiplikation in Schritt 126 unterzogen worden sind, dieser Faktor in den Schritten 218 und 224 ebenfalls berücksichtigt werden kann. Alternativ können freilich die durch den Prozeß von Fig. 11 erhaltenen Audiowerte einer weiteren Multiplikation unterzogen werden, um die um einer niedrigern Bitrate willen geschwächten Audiowerte wieder entsprechend zu verstärken.

Hinsichtlich der Figuren 3, 4, 6 und 9 - 11 wird darauf hingewiesen, daß dieselben Flußdiagramme zeigen, welche die Arbeitsweise des Codierers von Fig. 1 oder des Decodierers von Fig. 8 veranschaulichen, und daß jeder der in diesen Flußdiagrammen durch einen Block dargestellten Schritte wie beschrieben in einer entsprechenden Einrichtung implementiert ist, wie es im vorhergehenden beschrieben wurde. Die Implementierung der einzelnen Schritte kann dabei in Hardware, als ASIC-Schaltungsteil, oder in Software, als Unterroutinen, realisiert sein. Insbesondere zeigen in diesen Figuren die in den Blöcken eingeschrieben Erläuterungen grob an, auf welchen Vorgang sich der jeweilige Schritt bezieht, der dem jeweiligen Block entspricht, während die Pfeile zwischen den Blöcken die Reihenfolge der Schritte bei Betrieb des Codierers bzw. Dekodierers veranschaulichen.

Bezug nehmend auf die vorhergehende Beschreibung wird noch darauf hingewiesen, daß das oben dargestellte Codierschema in verschiedener Hinsicht variiert werden kann. Beispielsweise ist es nicht notwendig, daß eine Parametrisierung und ein Verstärkungswert oder eine Rauschleistungsgrenze, wie sie für einen bestimmten Audioblock bestimmt worden sind, als für einen bestimmten Audiowert unmittelbar gültig angesehen werden sollen, wie in dem vorhergehenden Ausführungsbeispiel der jeweils letzte Audiowert jedes Audioblocks, d.h. des 128sten Werts in diesem Audioblock, so daß für diesen Audiowert die Interpolation unterbleiben kann. Vielmehr ist es möglich, diese Stützstellenparameterwerte auf eine Stützstelle zu beziehen, die sich zeitlich zwischen den Abtastzeitpunkten $t_n$ mit n = 0, ..., 127 der Audiowerte dieses Audioblocks befindet, so daß für jeden Audiowert eine Interpolation notwendig wäre. Insbesondere kann die für einen Audioblock bestimmte Parametrisierung bzw. der für diesen Audioblock bestimmte Verstärkungswert auch auf einen anderen Wert unmittelbar angewendet werden, wie z.B. den Audiowert in der Mitte des Audioblocks, wie z.B. den 64sten Audiowert in dem Fall der obigen Blockgröße von 128 Audiowerten.

Ferner wird darauf hingewiesen, daß sich obiges Ausführungsbeispiel auf ein Audiocodierungsschema bezog, das darauf ausgelegt war, ein codiertes Signal mit einer gesteuerten Bitrate zu erzeugen. Die Steuerung der Bitrate ist aber nicht in jedem Anwendungsfall erforderlich. Deshalb können die entsprechenden Schritte 116 - 122 und 126 auch weggelassen werden.

Hinsichtlich des Bezug nehmend auf den Schritt 114 erwähnten Komprimierungsschemas wird der Vollständigkeit halber auch auf das in der Beschreibungseinleitung beschriebene Dokument von Schuller et.al. verwiesen, und insbesondere auf Gliederungspunkt IV, dessen Inhalt hiermit bezüglich der Redundanzreduktion mittels verlustloser Codierung hiermit unter Bezugnahme aufgenommen wird.

Ferner wird Bezug nehmend auf das vorhergehende Ausführungsbeispiel noch auf folgendes hingewiesen. Obwohl im Vorhergehenden beschrieben worden ist, daß der Schwellwert bei der Quantisierung immer konstant bleibt bzw. auch die Quantisierungsstufenfunktion immer konstant bleibt, d.h. stets die in dem gefilterten Audiosignal erzeugten Artefakte mit gröberer Quantisierung quantisiert bzw. abgeschnitten werden, wodurch die Audioqualität gegebenenfalls hörbar verschlechtert werden könnte, ist es ferner möglich, diese Maßnahme erst dann zu verwenden, wenn es die Komplexität des Audiosignals erfordert, nämlich dann, wenn die zur Codierung notwendige Bitrate eine erwünschte Bitrate überschreitet. In diesem Fall könnte zusätzlich zu den in Fig. 7a und 7b gezeigten Quantisierungsstufenfunktionen beispielsweise eine solche mit einer über den ganzen möglichen Wertebereich am Ausgang des Prefilters konstanten Quantisierungsschrittweite verwendet werden und der Quantisierer würde beispielsweise auf ein Signal ansprechen, um entweder die Quantisierungsstufenfunktion mit stets konstanter Quantisierungsschrittweite oder eine der Quantisierungsstufenfunktionen nach Fig. 7a oder 7b zu verwenden, so daß durch das Signal dem Quantisierer mitgeteilt werden könnte, bei geringfügiger Audioqualitätsverschlechterung die Quantisierungsstufenverringerung oberhalb des Schwellwertes bzw. das Abschneiden oberhalb des Schwellwertes durchzuführen. Alternativ könnte auch graduell der Schwellwert allmählich verringert werden. In diesem Fall könnte die Schwellwertverringerung anstatt der Faktorverringerung von Schritt 126 durchgeführt werden. Nach einem ersten Komprimierungsversuch ohne Schritt 110 könnte also das vorläufig komprimierte Signal lediglich erst dann in einem modifizierten Schritt 126 einer selektiven Schwellwertquantisierung unterzogen werden, wenn die Bitrate immer noch zu hoch ist (118). In einem erneuten Durchgang würden dann die gefilterten Audiowerte mit der Quantisierungsstufenfunktion quantisiert werden, die einen flacheren Verlauf oberhalb der Audioschwelle aufweist. Weitere Bitratenreduktionen könnten in dem modifizierten Schritt 126 noch durch Reduzieren des Schwellwertes und damit einer weiteren Modifikation der Quantisierungsstufenfunktion durchgeführt werden.

Ferner sind einige Aspekte obigen Ausführungsbeispiels zwar vorteilhaft, aber nicht notwendig. So könnte beispielsweise bei dem obigen Audiocodierschema die Interpolation weggelassen werden. Ferner wäre es möglich, die Parametrisierungen und den Verstärkungswert bzw. die Parametrisierungen und die Rauschleistungsgrenze bezüglich jeden Audioblocks zu übertragen, bezüglich dessen sie berechnet wurden, und keinen zu überspringen, wenn sich die aufeinanderfolgenden Parametrisierungen um weniger als vorerwähntes vorbestimmtes Maß unterscheiden.

Ferner wäre es möglich, die Differenzcodierung lediglich auf die Parametrisierungen anzuwenden, nicht aber auf den Verstärkungswert bzw. die Rauschleistungsgrenze.

Ferner ist es denkbar, bei obigem Codierungsschema die Filterkoeffizienten in den Differenz-Seitenblöcken 134 auch anders zu übertragen nämlich beispielsweise in Form der aktuellen Filterkoeffizienten minus der vorhergehend übertragenen Filterkoeffizienten minus der Mindestschwelle aus Schritt 66.

Oben beschriebenes Audiocodierschema beschäftigt sich folglich unter anderem mit der Übertragung von Seiteninformationen bei einem Audiocoder mit sehr geringer Verzögerungszeit auf effektive Art und Weise. Die Seiteninformationen, die für den Decoder übertragen werden müssen, damit das Audiosignal wieder geeignet rekonstruiert werden kann, haben die Eigenschaft, daß sich dieselben meistens nur langsam ändern. Deshalb werden nur Differenzen übertragen, was die Bitrate verringert. Zudem werden dieselben nur dann übertragen, wenn ausreichend Änderung da ist. Von Zeit zu Zeit wird der absolute Wert übertragen, falls vergangene Werte verlorengegangen sind. Anders ausgedrückt werden die Seiteninformationen vom Prefilter bzw. die Koeffizienten so übertragen, daß das Postfilter im Decodier die inverse Übertragungsfunktion besitzt, so daß das Audiosignal wieder passend rekonstruiert werden kann. Die dafür nötige Bitrate wird reduziert, indem Differenzen übertragen werden, und auch nur dann, wenn sie groß genug sind. Diese Differenzen haben kleinere Werte und kommen häufiger vor, weshalb sie weniger Bits bei der Codierung benötigen. Die Differenzcodierung zahlt sich insbesondere deshalb aus, weil sich die Differenzen bei sich kontinuierlich ändernden Audiosignalen auch nur stetig ändern.

Insbesondere wird darauf hingewiesen, dass abhängig von den Gegebenheiten das erfindungsgemäße Audiokodierungsschema auch in Software implementiert sein kann. Die Implementierung kann auf einem digitalen Speichermedium, insbesondere einer Diskette oder einer CD mit elektronisch auslesbaren Steuersignalen erfolgen, die so mit einem programmierbaren Computersystem zusammenwirken können, daß das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

Insbesondere können obige Verfahrensschritte in den Blöcken der Flußdiagramme einzeln oder zu mehreren in Unterprogrammroutinen implementiert sein. Alternativ ist freilich auch eine Implementierung einer erfindungsgemäßen Vorrichtung in Form einer Integrierten Schaltung möglich, bei der diese Blöcke beispielsweise als einzelne Schaltungsteile einer ASIC implementiert sind.

Insbesondere wird darauf hingewiesen, dass abhängig von den Gegebenheiten das erfindungsgemäße Schema auch in Software implementiert sein kann. Die Implementation kann auf einem digitalen Speichermedium, insbesondere einer Diskette oder einer CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

## Patentansprüche

1. Vorrichtung zum Codieren eines Audiosignals einer Folge von Audiowerten in ein codiertes Signal, mit

   einer Einrichtung(20) zum Ermitteln einer ersten Mithörschwelle für einen ersten Block von Audiowerten der Folge von Audiowerten und einer zweiten Mithörschwelle für einen zweiten Block von Audiowerten der Folge von Audiowerten;

   einer Einrichtung (24) zum Berechnen einer Version einer ersten Parametrisierung eines parametrisierbaren Filters (30), so daß dessen Übertragungsfunktion in etwa dem Inversen des Betrags der ersten Mithörschwelle entspricht, und einer Version einer zweiten Parametrisierung des parametrisierbaren Filters, so daß dessen Übertragungsfunktion in etwa dem Inversen des Betrags der zweiten Mithörschwelle entspricht;

einer Einrichtung (30) zum Filtern eines vorbestimmten Blocks von Audiowerten der Folge von Audiowerten mit dem parametrisierbaren Filter unter Verwendung einer vorbestimmten Parametrisierung, die in vorbestimmter Weise von der Version der zweiten Parametrisierung abhängt, um einen zu dem vorbestimmten Block korrespondierenden Block von gefilterten Audiowerten zu erhalten;

einer Einrichtung(28) zum Quantisieren der gefilterten Audiowerte, um einen Block von quantisierten, gefilterten Audiowerten zu erhalten;

einer Einrichtung zum Bilden einer Kombination der Version der ersten Parametrisierung und der Version der zweiten Parametrisierung, die aufeinanderfolgen und zumindest eine Differenz zwischen der Version der ersten Parametrisierung und der Version der zweiten Parametrisierung umfaßt; und

einer Einrichtung zum Einbinden von Informationen, aus denen die quantifizierten, gefilterten Audiowerte und eine Version der ersten Parametrisierung herleitbar sind, und die die Kombination umfassen, in das codierte Signal.

2.  Vorrichtung gemäß Anspruch 1, bei der die Einrichtung zum Filtern folgende Merkmale aufweist:

eine Einrichtung zum Interpolieren zwischen der Version der ersten Parametrisierung und der Version der zweiten Parametrisierung, um für einen vorbestimmten Audiowert des vorbestimmten Blocks von Audiowerten eine Version einer interpolierten Parametrisierung zu erhalten; und

eine Einrichtung zum Anwenden der Version der interpolierten Parametrisierung auf den vorbestimmten Audiowert.

3.  Vorrichtung gemäß einem der vorhergehenden Ansprüche, bei der die Einrichtung zum Einbinden einen Entropiecodierer umfaßt.

4.  Vorrichtung gemäß einem der vorhergehenden Ansprüche, bei der die Einrichtung zum Ermitteln der ersten und der zweiten Mithörschwelle und die Einrichtung zum Berechnen ausgebildet sind, um von dem ersten Block von Audiowerten an für eine Mehrzahl von nachfolgenden aufeinanderfolgenden Blöcken von Audiowerten der Folge von Audiowerten eine Mithörschwelle zu ermitteln bzw. eine Parametrisierung des parametrisierbaren Filters zu berechnen, so daß die Übertragungsfunktion desselben in etwa dem Inversen des Betrags der jeweiligen Mithörschwelle entspricht, wobei die Vorrichtung ferner folgendes Merkmal aufweist:

eine Einrichtung zum Überprüfen der Parametrisierungen der Reihe nach, ob sich dieselben um mehr als ein vorbestimmtes Maß von der ersten Parametrisierung unterscheiden, und zum Auswählen erst derjeniger Parametrisierung unter den Parametrisierungen als die zweite Parametrisierung, die sich erstmals um mehr als das vorbestimmte Maß von der ersten Parametrisierung unterscheidet.

5.  Vorrichtung gemäß Anspruch 4, bei dem die Kombination die Differenz minus das vorbestimmte Maß aufweist.

6.  Vorrichtung gemäß einem der vorhergehenden Ansprüche, die ferner eine Einrichtung (22) zum Ermitteln einer ersten Rauschleistungsgrenze abhängig von der ersten Maskierungsschwelle und einer zweiten Rauschleistungsgrenze abhängig von der zweiten Maskierungsschwelle aufweist, und bei der die Einrichtung zum Filtern eine Einrichtung (90) zum Interpolieren zwischen der ersten Rauschleistungsgrenze und der zweiten Rauschleistungsgrenze, um für einen vorbestimmten Audiowert des vorbestimmten Blocks von Audiowerten eine interpolierte Rauschleistungsgrenze zu erhalten, eine Einrichtung (92) zum Ermitteln eines Zwischenskalierungswerts abhängig von einer durch eine Quantisierung gemäß einer vorbestimmten Quantisierungsvorschrift hervorgerufenen Quantisierungsrauschleistung und der interpolierten Rauschleistungsgrenze, und eine Einrichtung (94) zum Anwenden des Zwischenskalierungswerts auf den vorbestimmten Audiowert, um einen skalierten, gefilterten Audiowerte zu erhalten, aufweist.

7.  Vorrichtung gemäß einem der vorhergehenden Ansprüche, die ausgebildet ist, um eine Mehrzahl aufeinanderfolgender vorbestimmter Blöcke zu verarbeiten und dabei in das codierte Signal intermittierend Informationen, die die quantifizierten, gefilterten Audiowerte und eine Version der ersten und der zweiten Parametrisierung umfassen, einzubauen.

8.  Verfahren zum Codieren eines Audiosignals einer Folge von Audiowerten in ein codiertes Signal, mit folgenden Schritten:

Ermitteln einer ersten Mithörschwelle für einen ersten Block von Audiowerten der Folge von Audiowerten und

**15**

einer zweiten Mithörschwelle für einen zweiten Block von Audiowerten der Folge von Audiowerten;

Berechnen einer Version einer ersten Parametrisierung eines parametrisierbaren Filters (30), so daß dessen Übertragungsfunktion in etwa dem Inversen des Betrags der ersten Mithörschwelle entspricht, und einer Version einer zweiten Parametrisierung des parametrisierbaren Filters, so daß dessen Übertragungsfunktion in etwa dem Inversen des Betrags der zweiten Mithörschwelle entspricht;

Filtern eines vorbestimmten Blocks von Audiowerten der Folge von Audiowerten mit dem parametrisierbaren Filter unter Verwendung einer vorbestimmten Parametrisierung, die in vorbestimmter Weise von der Version der zweiten Parametrisierung abhängt, um einen zu dem vorbestimmten Block korrespondierenden Block von gefilterten Audiowerten zu erhalten;

Quantisieren der gefilterten Audiowerte, um einen Block von quantisierten, gefilterten Audiowerten zu erhalten;

Bilden einer Kombination der Version der ersten Parametrisierung und der Version der zweiten Parametrisierung, die aufeinanderfolgen und zumindest eine Differenz zwischen der Version der ersten Parametrisierung und der Version der zweiten Parametrisierung umfaßt; und

Einbinden von Informationen, aus denen die quantifizierten, gefilterten Audiowerte herleitbar sind, und die die Kombination umfassen, in das codierte Signal.

9. Vorrichtung zum Decodieren eines codierten Signals in ein Audiosignal, wobei das codierte Signal Informationen enthält, aus denen ein Block von quantifizierten, gefilterten Audiowerten und eine Version einer ersten Parametrisierung, gemäß der eine Übertragungsfunktion eines parametrisierbaren Filters dem Inversen des Betrags einer ersten Mithörschwelle entspricht, herleitbar ist, und die eine Kombination zwischen einer Version einer zweiten Parametrisierung, gemäß der eine Übertragungsfunktion des parametrierbaren Filters dem Inversen eines Betrags einer zweiten Mithörschwelle entspricht, und der Version der ersten Parametrisierung, die aufeinanderfolgen und zumindest eine Differenz zwischen der Version der ersten Parametrisierung und der Version der zweiten Parametrisierung umfaßt, umfassen, mit

einer Einrichtung zum Herleiten der Version der ersten Parametrisierung aus dem codierten Signal;

einer Einrichtung zum Bilden einer Summe zwischen der Version der ersten Parametrisierung und der Differenz, um die Version der zweiten Parametrisierung zu erhalten; und

einer Einrichtung zum Filtern des Blocks von quantisierten, gefilterten Audiowerten mit einem parametrisierbaren Filter unter Verwendung der Version der zweiten Parametrisierung, derart, daß dessen Übertragungsfunktion in etwa dem Betrag der Mithörschwelle entspricht, um einen Block von dekodierten Audiowerten des Audiosignals zu erhalten.

10. Verfahren zum Decodieren eines codierten Signals in ein Audiosignal, wobei das codierte Signal Informationen enthält, aus denen ein Block von quantifizierten, gefilterten Audiowerten und eine Version einer ersten Parametrisierung, gemäß der eine Übertragungsfunktion eines parametrisierbaren Filters dem Inversen des Betrags einer ersten Mithörschwelle entspricht, herleitbar ist, und die eine Kombination zwischen einer Version einer zweiten Parametrisierung, gemäß der eine Übertragungsfunktion des parametrierbaren Filters dem Inversen eines Betrags einer zweiten Mithörschwelle entspricht, und der Version der ersten Parametrisierung, die aufeinanderfolgen und zumindest eine Differenz zwischen der Version der ersten Parametrisierung und der Version der zweiten Parametrisierung umfaßt, umfassen, mit folgenden Schritten:

Herleiten der Version der ersten Parametrisierung aus dem codierten Signal;

Bilden einer Summe zwischen der Version der ersten Parametrisierung und der Differenz, um die Version der zweiten Parametrisierung zu erhalten; und

Filtern des Blocks von quantisierten, gefilterten Audiowerten mit einem parametrisierbaren Filter unter Verwendung der Version der zweiten Parametrisierung, derart, daß dessen Übertragungsfunktion in etwa dem Betrag der Mithörschwelle entspricht, um einen Block von dekodierten Audiowerten des Audiosignals zu erhalten.

11. Computer-Programm mit einem Programmcode zur Durchführung des Verfahrens nach Anspruch 8 oder 10, wenn das Computer-Programm auf einem Computer abläuft.

## Claims

1. A device for coding an audio signal of a sequence of audio values into a coded signal, comprising:

means (20) for determining a first listening threshold for a first block of audio values of the sequence of audio values and a second listening threshold for a second block of audio values of the sequence of audio values;
means (24) for calculating a version of a first parameterization of a parameterizable filter (30) such that the transfer function thereof roughly corresponds to the inverse of the magnitude of the first listening threshold and a version of a second parameterization of the parameterizable filter such that the transfer function thereof roughly corresponds to the inverse of the magnitude of the second listening threshold;
means (30) for filtering a predetermined block of audio values of the sequence of audio values with the parameterizable filter using a predetermined parameterization which in a predetermined manner depends on the version of the second parameterization to obtain a block of filtered audio values corresponding to the predetermined block;
means (28) for quantizing the filtered audio values to obtain a block of quantized filtered audio values;
means for forming a combination of the version of the first parameterization and the version of the second parameterization following each other and including at least a difference between the version of the first parameterization and the version of the second parameterization; and
means for integrating information from which the quantized filtered audio values and a version of the first parameterization may be derived and which includes the combination into the coded signal.

2. The device according to claim 1, wherein the means for filtering comprises:

means for interpolating between the version of the first parameterization and the version of the second parameterization to obtain a version of an interpolated parameterization for a predetermined audio value of the predetermined block of audio values; and
means for applying the version of the interpolated parameterization to the predetermined audio value.

3. The device according to one of the preceding claims, wherein the means for integrating includes an entropy coder.

4. The device according to one of the preceding claims, wherein the means for determining the first and second listening thresholds and the means for calculating are formed to determine a listening threshold starting from the first block of audio values for a plurality of subsequent successive blocks of audio values of the sequence of audio values or to calculate a parameterization of the parameterizable filter such that the transfer function thereof roughly corresponds to the inverse of the magnitude of the respective listening threshold, the device further comprising:

means for checking the parameterizations one after the other whether they differ by more than a predetermined measure from the first parameterization and for selecting only that parameterization among the parameterizations as the second parameterization which for the first time differs by more than the predetermined measure from the first parameterization.

5. The device according to claim 4, wherein the combination comprises the difference minus the predetermined measure.

6. The device according to one of the preceding claims, further comprising means (22) for determining a first noise power limit depending on the first masking threshold and a second noise power limit depending on the second masking threshold, and wherein the means for filtering comprises means (90) for interpolating between the first noise power limit and the second noise power limit to obtain an interpolated noise power limit for a predetermined audio value of the predetermined block of audio values, means (92) for determining an intermediate scaling value depending on the quantizing noise power caused by quantization according to a predetermined quantizing rule and the interpolated noise power limit, and means (94) for applying the intermediate scaling value to the predetermined audio value to obtain a scaled filtered audio value.

7. The device according to one of the preceding claims, which is formed to process a plurality of successive predetermined blocks and thus to intermittently integrate information including the quantized filtered audio values and a version of the first and second parameterizations into the coded signal.

8. A method for coding an audio signal of a sequence of audio values into a coded signal, comprising the steps of:

determining a first listening threshold for a first block of audio values of the sequence of audio values and a second listening threshold for a second block of audio values of the sequence of audio values;
calculating a version of a first parameterization of a parameterizable filter (30) such that the transfer function thereof roughly corresponds to the inverse of the magnitude of the first listening threshold and a version of a second parameterization of the parameterizable filter such that the transfer function thereof roughly corresponds to the inverse of the magnitude of the second listening threshold;

filtering a predetermined block of audio values of the sequence of audio values with the parameterizable filter using a predetermined parameterization which in a predetermined manner depends on the version of the second parameterization to obtain a block of filtered audio values corresponding to the predetermined block;

quantizing the filtered audio values to obtain a block of quantized filtered audio values;

forming a combination of the version of the first parameterization and the version of the second parameterization following each other and including at least a difference between the version of the first parameterization and the version of the second parameterization; and

integrating information from which the quantized filtered audio values may be derived and which includes the combination into the coded signal.

9. A device for decoding a coded signal into an audio signal, the coded signal containing information from which a block of quantized filtered audio values and a version of a first parameterization according to which a transfer function of a parameterizable filter corresponds to the inverse of the magnitude of a first listening threshold may be derived, and which includes a combination between a version of a second parameterization according to which a transfer function of the parameterizable filter corresponds to the inverse of a magnitude of a second listening threshold and the version of the first parameterization following each other and including at least a difference between the version of the first parameterization and the version of the second parameterization, comprising:

means for deriving the version of the first parameterization from the coded signal;

means for calculating a sum between the version of the first parameterization and the difference to obtain the version of the second parameterization; and

means for filtering the block of quantized filtered audio values with a parameterizable filter using the version of the second parameterization such that the transfer function thereof roughly corresponds to the magnitude of the listening threshold to obtain a block of decoded audio values of the audio signal.

10. A method for decoding a coded signal into an audio signal, wherein the coded signal contains information from which a block of quantized filtered audio values and a version of a first parameterization according to which a transfer function of a parameterizable filter corresponds to the inverse of the magnitude of a first listening threshold may be derived, and which includes a combination between a version of a second parameterization according to which a transfer function of the parameterizable filter corresponds to the inverse of a magnitude of a second listening threshold and the version of the first parameterization following each other and including at least a difference between the version of the first parameterization and the version of the second parameterization, comprising the steps of:

deriving the version of the first parameterization from the coded signal;

calculating a sum between the version of the first parameterization and the difference to obtain the version of the second parameterization; and

filtering the block of quantized filtered audio values with a parameterizable filter using the version of the second parameterization such that the transfer function thereof roughly corresponds to the magnitude of the listening threshold to obtain a block of decoded audio values of the audio signal.

11. A computer program having a program code for performing the method according to claims 8 or 10 when the computer program runs on a computer.

**Revendications**

1. Dispositif de codage d'un signal audio d'une séquence de valeurs audio, pour obtenir un signal codé, avec

un moyen (20) pour déterminer un premier seuil d'écoute pour un premier bloc de valeurs audio de la séquence de valeurs audio et un deuxième seuil d'écoute pour un deuxième bloc de valeurs audio de la séquence de valeurs audio;

un moyen (24) pour calculer une version d'une première paramétrisation d'un filtre paramétrisable (30), de sorte que sa fonction de transmission corresponde environ à l'inverse de la quantité du premier seuil d'écoute, et une version d'une deuxième paramétrisation du filtre paramétrisable, de sorte que sa fonction de transmission corresponde environ à l'inverse de la quantité du deuxième seuil d'écoute;

un moyen (30) pour filtrer un bloc prédéterminé de valeurs audio de la séquence de valeurs audio par le filtre paramétrisable à l'aide d'une paramétrisation prédéterminée qui est fonction de manière prédéterminée de la version de la deuxième paramétrisation, pour obtenir un bloc de valeurs audio filtrées correspondant au bloc prédéterminé;

un moyen (28) pour quantifier les valeurs audio filtrées, pour obtenir un bloc de valeurs audio filtrées quantifiées;

un moyen pour former une combinaison de la version de la première paramétrisation et de la version de la deuxième paramétrisation qui se succèdent et qui comprend au moins une différence entre la version de la première paramétrisation et la version de la deuxième paramétrisation; et

un moyen pour incorporer des informations dans le signal codé desquelles peuvent être dérivées les valeurs audio filtrées quantifiées et une version de la première paramétrisation, et comprenant la combinaison.

2. Dispositif selon la revendication 1, dans lequel le moyen pour filtrer présente les caractéristiques suivantes:

un moyen pour interpoler entre la version de la première paramétrisation et la version de la deuxième paramétrisation, pour obtenir, pour une valeur audio prédéterminée du bloc prédéterminé de valeurs audio, une version d'une paramétrisation interpolée; et

un moyen pour appliquer la version de la paramétrisation interpolée à la valeur audio prédéterminée.

3. Dispositif selon l'une des revendications précédentes, dans lequel le moyen pour incorporer comporte un codeur entropique.

4. Dispositif selon l'une des revendications précédentes, dans lequel le moyen pour déterminer le premier et le deuxième seuil d'écoute est réalisé de manière à déterminer, à partir du premier bloc de valeurs audio, pour une pluralité de blocs successifs de valeurs audio de la succession de valeurs audio, un seuil d'écoute ou à calculer une paramétrisation du filtre paramétrisable, de sorte que la fonction de transmission de celui-ci corresponde environ à l'inverse du montant du seuil d'écoute respectif, le dispositif présentant par ailleurs la caractéristique suivante:

un moyen pour examiner dans l'ordre les paramétrisations, pour savoir si elles diffèrent de la première paramétrisation de plus d'une mesure prédéterminée, et pour sélectionner comme deuxième paramétrisation tout d'abord la paramétrisation parmi les paramétrisations qui diffère pour la première fois de la première paramétrisation de plus de la mesure prédéterminée.

5. Dispositif selon la revendication 4, dans laquelle la combinaison présente la différence moins la mesure prédéterminée.

6. Dispositif selon l'une des revendications précédentes, présentant par ailleurs un moyen (22) pour déterminer une première limite de puissance de bruit en fonction du premier seuil de masquage et une deuxième limite de puissance de bruit en fonction du deuxième seuil de masquage, et dans lequel le moyen pour filtrer présente un moyen (90) pour interpoler entre la première limite de puissance de bruit et la deuxième limite de puissance de bruit, pour obtenir, pour une valeur audio prédéterminée du bloc prédéterminé de valeurs audio, une limite de puissance de bruit interpolée, un moyen (92) pour déterminer une valeur de modulation intermédiaire en fonction d'une puissance de bruit de quantification créée par une quantification selon une règle de quantification prédéterminée et de la limite de puissance de bruit interpolée, et un moyen (94) pour appliquer la valeur de modulation intermédiaire à la valeur audio prédéterminée, pour obtenir une valeur audio filtrée modulée.

7. Dispositif selon l'une des revendications précédentes, qui est réalisé de manière à traiter une pluralité de blocs prédéterminés successifs et à incorporer dans le signal codé par intermittence des informations qui comportent les valeurs audio filtrées quantifiées et une version de la première et de la deuxième paramétrisation.

8. Procédé pour coder un signal audio d'une séquence de valeurs audio, pour obtenir un signal codé, avec les étapes suivantes consistant à:

déterminer un premier seuil d'écoute pour un premier bloc de valeurs audio de la séquence de valeurs audio et un deuxième seuil d'écoute pour un deuxième bloc de valeurs audio de la séquence de valeurs audio;

calculer une version d'une première paramétrisation d'un filtre paramétrisable (30), de sorte que sa fonction de transmission corresponde environ à l'inverse de la quantité du premier seuil d'écoute, et une version d'une deuxième paramétrisation du filtre paramétrisable, de sorte que sa fonction de transmission corresponde environ à l'inverse de la quantité du deuxième seuil d'écoute;

filtrer un bloc prédéterminé de valeurs audio de la séquence de valeurs audio par le filtre paramétrisable à l'aide d'une paramétrisation prédéterminée qui est fonction de manière prédéterminée de la version de la deuxième paramétrisation, pour obtenir un bloc de valeurs audio filtrées correspondant au bloc prédéterminé;

quantifier les valeurs audio filtrées, pour obtenir un bloc de valeurs audio filtrées quantifiées;

former une combinaison de la version de la première paramétrisation et de la version de la deuxième paramétrisation qui se succèdent et qui comprend au moins une différence entre la version de la première paramétrisation et la version de la deuxième paramétrisation; et

incorporer des informations dans le signal codé desquelles peuvent être dérivées les valeurs audio filtrées quantifiées, et comprenant la combinaison.

**9.** Dispositif pour décoder un signal codé, pour obtenir un signal audio, le signal codé contenant des informations desquelles peuvent être dérivés un bloc de valeurs audio filtrées quantifiées et une version d'une première paramétrisation selon laquelle une fonction de transmission d'un filtre paramétrisable correspond à l'inverse de la quantité d'un premier seuil d'écoute, et comprenant une combinaison entre une version d'une deuxième paramétrisation selon laquelle l'une fonction de transmission du filtre paramétrisable correspond à l'inverse d'une quantité d'un deuxième seuil d'écoute, et la version de la première paramétrisation qui se succèdent et qui comprend au moins une différence entre la version de la première paramétrisation et la version de la deuxième paramétrisation, avec

un moyen pour dériver du signal codé la version de la première paramétrisation;

un moyen pour former une somme entre la version de la première paramétrisation et la différence, pour obtenir la version de la deuxième paramétrisation; et

un moyen pour filtrer le bloc de valeurs audio filtrées quantifiées par un filtre paramétrisable à l'aide de la version de la deuxième paramétrisation, de sorte que sa fonction de transmission corresponde environ à la quantité du seuil d'écoute, pour obtenir un bloc de valeurs audio décodées du signal audio.

**10.** Procédé pour décoder un signal codé, pour obtenir un signal audio, le signal codé contenant des informations desquelles peuvent être dérivés un bloc de valeurs audio filtrées quantifiées et une version d'une première paramétrisation selon laquelle une fonction de transmission d'un filtre paramétrisable correspond à l'inverse de la quantité d'un premier seuil d'écoute, et comprenant une combinaison entre une version d'une deuxième paramétrisation selon laquelle l'une fonction de transmission du filtre paramétrisable correspond à l'inverse d'une quantité d'un deuxième seuil d'écoute, et la version de la première paramétrisation qui se succèdent et qui comprend au moins une différence entre la version de la première paramétrisation et la version de la deuxième paramétrisation, aux étapes suivantes consistant à:

dériver du signal codé la version de la première paramétrisation;

former une somme entre la version de la première paramétrisation et la différence, pour obtenir la version de la deuxième paramétrisation; et

filtrer le bloc de valeurs audio filtrées quantifiées par un filtre paramétrisable à l'aide de la version de la deuxième paramétrisation, de sorte que sa fonction de transmission corresponde environ à la quantité du seuil d'écoute, pour obtenir un bloc de valeurs audio décodées du signal audio.

**11.** Programme d'ordinateur avec un code de programme pour réaliser le procédé selon la revendication 8 ou 10 lorsque le programme d'ordinateur est exécuté sur un ordinateur.

FIG. 1

EP 1 697 928 B1

ANALOGES
AUDIOSIGNAL

AUDIOSIGNALABTASTUNG — 50

AUDIOWERTE DES AB-
GETASTETEN AUDIOSIGNALS

ZUSAMMENFASSEN AUF-
EINANDERFOLGENDER
AUDIOWERTE VORBE-
STIMMTER ANZAHL ZU
AUDIOBLÖCKEN — 52

AUDIOBLÖCKE

ZWISCHENSPEICHERN
DER AUDIOBLÖCKE — 54

FIG. 2

EP 1 697 928 B1

BEGINN

NÄCHSTER
AUDIOBLOCK
VOLLSTÄNDIG?  NEIN

60

JA

MITTELS PSYCHOAKUSTISCHEM MODELL BERECHNEN
EINER MITHÖRSCHWELLE

62

BERECHNEN EINES VERSTÄRKUNGSWERTES SOWIE
EINER PARAMETRISIERUNG AUS DER
MITHÖRSCHWELLE

64

66

UNTERSCHEIDET
SICH DIE SOEBEN BERECHNETE
PARAMETRISIERUNG UM MEHR ALS EINE
VORBESTIMMTE SCHWELLE
VON DER AKTUELLEN?

NEIN

JA

ÜBERGEBEN DER SOEBEN BE-
RECHNETEN FILTER-KOEFFIZIENTEN
AN PREFILTER

68

ÜBERGEBEN DES SOEBEN BE-
RECHNETEN VERSTÄRKUNGS-
WERTES AN PREFILTER

70

72

ÜBERGEBEN DER AKTUELLEN
FILTERKOEFFIZIENTEN UND DES
AKTUELLEN VERSTÄR-
KUNGSWERTS AN PREFILTER

FIG. 3

BEGINN

80 ÜBERGABE SOEBEN BERECHNETER FILTERKOEFFIZIENTEN UND EINES NEUEN VERSTÄRKUNGS-RTES

NEIN

JA | $a_1$, $x_1(i)$

84 ERMITTELN RAUSCHLEISTUNGS-GRENZE AN DER NEUEN STÜTZSTELLE

$q_1$

86 $j = 128$

88 INTERPOLATION DER FILTERKOEFFI-ZIENTEN ZWISCHEN DER NEUEN UND DER VORHERGEHENDEN STÜTZSTELLE, UM DEN INTERPOLIERTEN FILTER-KOEFFIZIENT AN DER ABTAST-POSITION j ZU ERHALTEN

$x(t_j)(i)$

90 INTERPOLATION DER RAUSCHLEIS-TUNGSGRENZE ZWISCHEN DEN STÜTZ-STELLEN, UM DIE INTERPOLIERTE RAUSCHLEISTUNGSGRENZE AN DER ABTASTPOSITION j ZU ERHALTEN

$q(t_j)$

92 BERECHNEN DES VERSTÄRKUNGS-WERTES FÜR DIE ABTASTPOSITION j AUF DER BASIS DER INTERPOLIERTEN RAUSCHLEISTUNGSGRENZE UND DER QUANTISIERUNGSRAUSCHLEISTUNG

$a(t_j)$

94 ANWENDEN DES BERECHNETEN VER-STÄRKUNGSWERTES SOWIE DER INTER-POLIERTEN FILTERKOEFFIZIENTEN AUF DEN ABTASTWERT AN DIESER ABTASTPOSITION j

$s'(t_j)$

98 $j = j + 1$

NEIN

96 STÜTZ-STELLE ER-REICHT?

JA

100 ANWENDEN DES VERSTÄRKUNGS-WERTES UND DER FILTER-KOEFFIZIENTEN DER NEUEN STÜTZ-STELLE AUF DEN ABTASTWERT AN DER NEUEN STÜTZSTELLE

FIG. 4

EP 1 697 928 B1

| 56 | BLOCK 0 | | | | | | | | | | BLOCK 1 | | | | | | BLOCK 2 | | | | | |
|---|---|---|---|---|---|---|---|---|---|---|---|---|---|---|---|---|---|---|---|---|---|---|
| ⋯ | 0 | 1 | 2 | 3 | ⋯ | 125 | 126 | 127 | 128 | 129 | ⋯ | 253 | 254 | 255 | 256 | 257 | 258 | 259 | ⋯ | 383 | ⋯ | |

$54$ ⬆ $a_0$ $x_0(i)$ — 90

DIREKTE ANWENDUNG — 81

88 — LINEARE INTERPOLATION 92 — ⬆ $a_1$ $x_1(i)$

⬇ $q_0$

90 — LINEARE INTERPOLATION ⬇ —84 $q_1$

INTERPOLATION —82

**FIG. 5a**

130 132 t 134

| $a_0$, $x_0(i)$ | $\sigma'(t_0)$ | $\sigma'(t_1)$ | ⋯ | $\sigma'(t_{254})$ | $\sigma'(t_{255})$ | $a_1$-$a_0$, $x_1(i)$-$x_0(i)$ | $\sigma'(t_{256})$ | ⋯ |
|---|---|---|---|---|---|---|---|---|

SEITEN-INFORMATIONEN      HAUPTDATEN      SEITEN-INFORMATIONEN

**FIG. 5b**

ANWENDER EINER OBEREN
SCHRANKE AUF DIE WERTE ⎯110
DES GEFILTERTEN SIGNALS

QUANTISIEREN DER BEGRENZTEN
WERTE DES GEFILTERTEN ⎯112
SIGNALS

KOMPRIMIEREN DES QUANTISIERTEN
SIGNALS PLUS FILTERKOEFFIZIENTEN- ⎯114
DIFFERENZEN UND VERSTÄRKUNGSWERT

116

KOMPRES-
NEIN ← SIONSBLOCKGRÖSSE
ERREICHT?

JA

118

BIT-
MENGE GRÖSSER ALS JA
NEIN VON BITRATE VORGE-
SCHRIEBEN?

126

ANWENDEN EINES
FAKTORS ∈ ]0,1[ AUF
JEDEN DER WERTE DES
GEFILTERTEN SIGNALS
IN DEM KOMPRES-
SIONSBLOCK

120

BIT-
MENGE KLEINER ALS
VON BITRATE VORGE-
SCHRIEBEN? JA

NEIN

AUFFÜLLEN
MIT BITS

122

ANWENDEN EINES FAKTORS
GRÖSSER 1 AUF JEDEN DER
WERTE DES GEFILTERTEN
SIGNALS IN DEM
KOMPRESSIONSIONSBLOCK

125

FIG. 6

AUSGEBEN DER
KOMPRIMIERTEN DATEN ⎯124

$\sigma'$

FIG. 7a

SCHWELLENWERT

$s'$

$\sigma'$

HÖCHSTE →
QUANTISIERUNGS-
STUFE

SCHRITTWEITE

SCHWELLENWERT

$s'$

FIG. 7b

DARSTELLBARER BEREICH
DER FLIESSKOMMADARSTELLUNG

**FIG. 8**

KOMPRIMIERTES SIGNAL

DEKOMPRIMIEREN DES KOMPRIMIERTEN SIGNALS — 224

QUANTISIERTE, GEFILTERTE AUDIODATEN UND SEITENINFORMATIONEN

**FIG. 9**

226 SEITEN-INFORMATIONEN MIT FILTERKOEFFIZIEN-TEN? — NEIN

JA $a_0, x_0(i)$

228 — EMPFANGEN UND ZWISCHEN-SPEICHERN VON QUANTISIERTEN, GEFILTERTEN AUDIODATEN

230 SEITEN-INFORMATIONEN MIT FILTERKOEFFIZIENTEN-DIFFERENZEN? — NEIN

JA

232 — BERECHNUNG VON $a_1, x_1(i)$, FALLS FILTERKOEFFIZIENTEN-DIFFERENZEN

**FIG. 10**

# FIG. 11

$q_0, x_0(i)$
$a_1, x_1(i)$
$s'(t_0)\text{-}s'(t_{255})$

$j=0$ — 234

236

BERECHNUNG DER RAUSCH-
LEISTUNGSGRENZE AN DER
NEUEN STÜTZSTELLE

$q_1$     238

INTERPOLATION DER FILTER-
KOEFFIZIENTEN ZWISCHEN DER NEUEN
UND DER VORHERGEHENDEN STÜTZ-
STELLE, UM DEN INTERPOLIERTEN
FILTERKOEFFIZIENTEN AN DER
ABTASTPOSITION j ZU ERHALTEN

$x(t_1)(i)$     240

INTERPOLATION DER RAUSCHLEIS-
TUNGSGRENZE ZWISCHEN DEN STÜTZ-
STELLEN, UM DIE INTERPOLIERTE
RAUSCHLEISTUNGSGRENZE AN DER
AKTUELLEN ABTASTPOSITION j
ZU ERHALTEN

$q(t_1)$     242

BERECHNEN DES VERSTÄRKUNGS-
WERTES FÜR DIE ABTASTPOSITION j
AUF DER BASIS DER INTERPOLIERTEN
RAUSCHLEISTUNGSGRENZE UND DEN
INTERPOLIERTEN FILTERKOEFFIZIENTEN

244

ANWENDEN DES BERECHNETEN VER-
STÄRKUNGSWERTES SOWIE DER
INTERPOLIERTEN FILTERKOEFFIZIENTEN
AUF DEN ABTASTWERT AN DER
ABTASTPOSITION j

246

STÜTZ-
STELLE ER-
REICHT?

NEIN → $j=j+1$

248

JA

250

ANWENDEN DES
VERSTÄRKUNGSWERTES UND
DES FILTERKOEFFIZIENTEN DER
NEUEN STÜTZSTELLE AUF DEN
ABTASTWERT AN DER NEUEN
STÜTZSTELLE

30

902

908

t

906

904

...                                                                    ...

BLOCK 0          BLOCK 1          BLOCK 2

$a_0$              $a_1$              $a_2$
$x_0(i)$            $x_1(i)$            $x_2(i)$

IRRELEVANZREDUKTION

910                                        912

t

$a_\#, x_\#(i)$          HAUPTDATEN

SEITENINFORMATION

914

REDUNDANZREDUKTION

KODIERTES
SIGNAL

FIG. 12
STAND DER TECHNIK

31

FIG. 13 STAND DER TECHNIK

EP 1 697 928 B1

**IN DER BESCHREIBUNG AUFGEFÜHRTE DOKUMENTE**

**In der Beschreibung aufgeführte Nicht-Patentliteratur**

- **Schuller G.** Perceptual Audio Coding using Adaptive Pre- and Post-Filters and Lossless Compression. *IEEE Transactions on Speech and Audio Processing,* September 2002, vol. 10 (6), 379-390